# EUROPEAN PATENT APPLICATION

(11) **EP 4 443 012 A1**
(43) Date of publication of application: **09.10.2024**
(21) Application number: 23746210.6
(22) Date of filing: 18.01.2023
(51) Int. Cl.: F16C 11/04

(54) **HINGE MECHANISM AND ELECTRONIC DEVICE**

(30) Priority: 30.01.2022 CN 202210113973
(71) Applicant: Huawei Technologies Co., Ltd., Shenzhen, Guangdong 518129 (CN)
(72) Inventor: WU, Weifeng, Shenzhen, Guangdong 518129 (CN); ZHONG, Ding, Shenzhen, Guangdong 518129 (CN); ZHAN, Qiang, Shenzhen, Guangdong 518129 (CN); HUA, Leilei, Shenzhen, Guangdong 518129 (CN); XIAO, Zhenlin, Shenzhen, Guangdong 518129 (CN); ZHANG, Zhibin, Shenzhen, Guangdong 518129 (CN); LIAO, Changliang, Shenzhen, Guangdong 518129 (CN)
(74) Representative: Thun, Clemens
(86) International application number: PCT/CN2023/072989
(87) International publication number: WO 2023/143329

(57) **Abstract**

A hinge mechanism and an electronic device are disclosed. The hinge mechanism (1) includes a base (1020) and a main hinge module (101). The base (1020) includes a support surface for supporting a flexible display (4). The main hinge module (101) includes a first rotating component (101a) and a second rotating component (101b). The first rotating component (101a) and the second rotating component (101b) are disposed on two opposite sides of the base (1020). The first rotating component (101a) includes a first support plate (102), and the first support plate (102) includes a first plate surface (102a) for supporting the flexible display (4). The second rotating component (101b) includes a second support plate (103), and the second support plate (103) includes a second plate surface (103a) for supporting the flexible display (4). When the hinge mechanism is in a folded state, an included angle between the first plate surface (102a) and a bearing surface (102a) is less than an included angle between the second plate surface (103a) and the bearing surface (102a), to form display accommodating space between the first plate surface (102a), the second plate surface (103a), and the bearing surface (102a). The display accommodating space formed by the apparatus between the two support plates and the base is a tilted triangular interval. This helps reduce a width of the hinge mechanism, and can enable a width of a bent area of the flexible display to be small.

## Description

### CROSS-REFERENCE TO RELATED APPLICATIONS

This application claims priority to Chinese Patent Application No. 202210113973.0, filed with the China National Intellectual Property Administration on January 30, 2022 and entitled "HINGE MECHANISM AND ELECTRONIC DEVICE", which is incorporated herein by reference in its entirety.

### TECHNICAL FIELD

This application relates to the field of electronic device technologies, and in particular, to a hinge mechanism and an electronic device.

### BACKGROUND

With gradual maturation of flexible display technologies, a display manner of an electronic device is driven to greatly change. A mobile phone with a foldable flexible display, a tablet computer with a foldable flexible display, a wearable electronic device with a foldable flexible display, or the like is an important evolution direction of an intelligent electronic device in the future.

A flexible display is a key component of a foldable electronic device, and has features of continuity and foldability. A hinge mechanism serves as an important component for implementing a folding function of the foldable electronic device. When the foldable electronic device is in a folded state, the hinge mechanism may form display accommodating space for accommodating a bent part of the flexible display, to avoid pulling or squeezing the flexible display. However, the display accommodating space formed by the hinge mechanism in the current foldable electronic device is symmetric space, so that the bent part of the flexible display is in a symmetric water-drop-like form. As a result, when the foldable electronic device is in an unfolded state, the flexible display has a large crease width, and this affects user experience.

Therefore, how to reduce a crease width of a flexible display of a foldable electronic device and improve light and shadow has become a difficult problem to be urgently resolved by a person skilled in the art.

### SUMMARY

This application provides a hinge mechanism and an electronic device, to reduce a crease width of a flexible display of an electronic device, improve light and shadow of the flexible display, and improve user experience.

According to a first aspect, this application provides a hinge mechanism. The hinge mechanism is used in a foldable electronic device, the hinge mechanism is disposed corresponding to a bendable part of a flexible display of the electronic device, and the electronic device is unfolded or folded via the hinge mechanism. When the hinge mechanism is specifically disposed, the hinge mechanism may include a base and a main hinge module. The base includes a bearing surface, and the bearing surface is configured to support the flexible display. The main hinge module includes a first rotating component and a second rotating component, and the first rotating component and the second rotating component are disposed on two opposite sides of the base. The first rotating component includes a first support plate, the first support plate includes a first plate surface, and the first plate surface is configured to support the flexible display. The second rotating component includes a second support plate, the second support plate includes a second plate surface, and the second plate surface is configured to support the flexible display. In addition, when the hinge mechanism is in a folded state, an included angle between the first plate surface and the bearing surface is less than an included angle between the second plate surface and the bearing surface, to form, between the first plate surface, the second plate surface, and the bearing surface, display accommodating space for accommodating the bendable part of the flexible display. Herein, the folded state of the hinge mechanism definitely indicates that the two rotating components of the hinge mechanism are seamlessly fit, but a state corresponding to the hinge mechanism when the electronic device is in a folded state.

In the hinge mechanism provided in this application, the first rotating component and the second rotating component are disposed in an asymmetric manner relative to each other or relative to the base. The hinge mechanism can be used to form, between the first support plate, the second support plate, and the base, triangular display accommodating space that tilts towards a side of the first support plate. When the hinge mechanism is used in the electronic device, the bendable part of the flexible display of the electronic device can be accommodated in the display accommodating space, and is in an asymmetrical water-drop-like form. This can prevent the flexible display from being squeezed, effectively reduce a width of a bent area of the flexible display while reducing a risk of damage to the flexible display, and help improve user experience. In addition, because two sides of the hinge mechanism do not need to be in totally same structures, a structure design on one side of the hinge structure can be simplified, and an overall structure of the hinge mechanism can be simplified based on such a design.

In a possible implementation of this application, the first rotating component further includes a first support arm and a housing mounting bracket, the first support arm is rotatably connected to the base, the first support arm is slidably connected to the housing mounting bracket, and the first support plate is rotatably connected to the housing mounting bracket. In addition, the second support plate is rotatably connected to the base. In this way, when the hinge mechanism is in an unfolded state, the first plate surface of the first support plate, the second plate surface of the second support plate, and the bearing surface of the base can all smoothly support the flexible display. In addition, when the first rotating component and the second rotating component rotate towards each other, the first support plate rotates around the housing mounting bracket, and an end, of the first support plate, close to the base moves in a direction away from the base. However, in a rotation process, the second support plate is always rotatably connected to the base, and rotation axis centers of the first support plate and the second support plate do not overlap. This can form, between the first support plate and the second support plate, the triangular display accommodating space that tilts towards the side of the first support plate.

To implement rotation of the first support plate around the housing mounting bracket, a rotating slot can be disposed on the housing mounting bracket, and a rotating part is disposed on the first support plate. In this way, the rotating part can be installed in the rotating slot, and the rotating part can rotate along a slot surface of the rotating slot.

In this application, the first rotating component may further include a swing arm, the swing arm may rotatably be connected to the base, and a rotation axis of the first support arm is parallel to but does not overlap a rotation axis of the swing arm. Therefore, phase difference motion effect between the swing arm and the first support arm can be implemented, so that in the rotation process of the hinge mechanism, the first rotating component performs a telescopic motion relative to the base, and the hinge mechanism can adapt to a length of the flexible display. This avoids pulling or squeezing the flexible display, reduces a risk of damage to the flexible display, and prolongs a service life of the flexible display.

In addition, in a process in which the second rotating component rotates around the base, a distance between the second rotating component relative to the base does not extend. This can have a simple structure design of a second rotating component side of the hinge mechanism, occupy small space, and help reduce a volume of the entire hinge mechanism. In this case, the electronic device in which the hinge mechanism is used can reserve more space for disposing components such as a battery or a circuit board. This helps improve performance of the electronic device.

It can be learned from the foregoing description of the hinge mechanism that when the first rotating component and the second rotating component rotate towards each other, the first support plate can rotate around the housing mounting bracket. This can form the display accommodating space between the first support plate and the second support plate. To form, between the two support plates, the display accommodating space that meets a bent requirement of the flexible display, a motion track of the first support plate can be appropriately designed. In a possible implementation of this application, the first support plate may be slidably connected to the first support arm, to drive the first support plate to rotate around the housing mounting bracket by rotating the first support arm around the base. In addition, the first support plate may be slidably connected to the swing arm, to drive the first support plate to rotate around the housing mounting bracket by rotating the swing arm around the base. Alternatively, the first support plate may be slidably connected to both the first support arm and the swing arm, to drive the first support plate to rotate around the housing mounting bracket by rotating the first support arm and the swing arm around the base.

During specific implementation, when the first support plate is slidably connected to the first support arm, a first guiding part may be disposed on the first support plate, and the first guiding part is provided with a first track slot. In addition, a first guiding structure may be disposed on the first support arm, and the first guiding structure may be inserted into the first track slot and can slide along the first track slot. Therefore, in a process in which the swing arm and the first support arm rotate around the base, the first support plate is driven to rotate around the housing mounting bracket, and a motion track of the first support plate is adjusted by sliding the first guiding structure in the first track slot. This forms, between the two support plates, the display accommodating space that meets a screen-accommodating requirement.

In addition/Alternatively, when the first support plate is slidably connected to the swing arm, a first guiding structure may be disposed on the swing arm, and the first guiding structure may be inserted into the first track slot and can slide along the first track slot. Therefore, in a process in which the swing arm rotates around the base, the first support plate is driven to rotate around the housing mounting bracket, and a motion track of the first support plate is adjusted by sliding the first guiding structure in the first track slot. This forms, between the two support plates, the display accommodating space that meets a screen-accommodating requirement.

In this application, the swing arm is rotatably connected to the base in multiple manners. For example, a first arc-shaped slot may be disposed on the base, and a first arc-shaped rotation block is disposed at an end, of the swing arm, rotatably connected to the base. In this way, the first arc-shaped rotation block can be accommodated in the first arc-shaped slot, and the first arc-shaped rotation block rotates along an arc-shaped surface of the first arc-shaped slot, so that the swing arm is rotatably connected to the base. The swing arm is rotatably connected to the base through a virtual shaft, and this can effectively reduce space occupied by the swing arm on the base and facilitate a miniaturization design of the hinge mechanism.

In addition, the hinge mechanism may further include a cover plate, and the cover plate may cover the base, to form accommodating space between the base and the cover plate. In addition, an arc-shaped protrusion may be disposed on a surface, of the cover plate, facing the first arc-shaped slot, and the first arc-shaped rotation block of the swing arm may be inserted between the arc-shaped protrusion and the first arc-shaped slot. This limits the first arc-shaped rotation block on the base, prevents the first arc-shaped rotation block from falling off from the base, and improves reliability of a connection between the swing arm and the base. In a possible implementation of this application, the first arc-shaped slot may alternatively be of an integrated channel structure directly disposed on the base, and can effectively simplify a structure of the base while ensuring reliability of a connection between the first arc-shaped rotation block and the first arc-shaped slot.

In a possible implementation of this application, the swing arm is slidably connected to the housing mounting bracket. A first sliding groove extending in a first direction and a second sliding groove extending in a second direction may be disposed on the housing mounting bracket, the first support arm can slide in the first sliding groove, and the swing arm can slide in the second sliding groove. In addition, a projection along the first direction in a first cross section is not parallel to a projection along the second direction in the first cross section. The first cross section is a reference plane perpendicular to the rotation axis of the first support arm and the rotation axis of the swing arm. This can adjust, by appropriately designing disposing directions of the first sliding groove and the second sliding groove, angles at which the first support arm and the swing arm rotate relative to the base. For example, the rotation angles of the first support arm and the swing arm may be not greater than 90°. Therefore, the angles at which a first swing arm and a second swing arm rotate relative to the base can be small, so that another structure on the hinge mechanism can be prevented from avoiding rotation of the swing arm. This can help increase a wall thickness of a local structure of the swing arm, and improve structural reliability of the swing arm. In addition, when being used in the electronic device, the hinge mechanism can effectively avoid a case in which a component in the electronic device is thinning designed, to avoid rotation of the swing arm. This can improve reliability of an overall structure of the electronic device; and can reduce a risk of squeezing the flexible display of the electronic device caused by rotation of the swing arm, reduce the risk of damage to the flexible display, and prolong the service life of the flexible display.

In a possible implementation of this application, a first sliding rail may be disposed on a slot wall of the first sliding groove of the housing mounting bracket, and a first sliding block may be disposed on the first support arm. The first sliding block may be clamped on the first sliding rail, and may slide along the first sliding rail. This can prevent the first support arm from falling off from the housing mounting bracket. The first sliding rail can provide guidance for sliding of the first support arm, and this improves reliability of sliding the first support arm along the housing mounting bracket.

Similarly, a second sliding rail may be disposed on a slot wall of the second sliding groove of the housing mounting bracket, and a second sliding block is disposed on the swing arm. The second sliding block may be clamped on the second sliding rail, and may slide along the second sliding rail. This can prevent the swing arm from falling off from the housing mounting bracket. The second sliding rail can provide guidance for sliding of the swing arm, and this improves reliability of sliding the swing arm along the housing mounting bracket.

In addition, in this application, when the second sliding block is specifically disposed, the second sliding block may be a straight-line sliding block. In this case, the second sliding rail may be adaptively disposed as a straight-line sliding rail. This can effectively simplify a processing process of the second sliding block and the second sliding rail. It may be understood that the second sliding block herein may alternatively be another shape that adapts to the straight-line sliding rail, for example, may be a sliding block in an overall straight-line form with a hollow and spacing design in a middle part, or may be some special-shaped sliding blocks, as long as the sliding block can fit the sliding rail in the straight-line form for sliding.

In a possible implementation of this application, the housing mounting bracket includes a first surface, and the first surface is a side surface, of the housing mounting bracket, facing the flexible display. In this case, when the hinge mechanism is in the unfolded state, the straight-line sliding rail can extend from an opening to a direction of the base. This can help improve smoothness of sliding the second sliding block along the second sliding rail, effectively reduce interference of another structure on the hinge mechanism on motion of the swing arm, and help increase a wall thickness of the swing arm. In another possible implementation of this application, the straight-line sliding rail may alternatively extend from an opening to a direction away from the base; or when the housing mounting bracket further includes a second surface disposed opposite to the first surface, the straight-line sliding rail may also extend from an opening to a direction perpendicular to the second surface, so that the second sliding rail is disposed flexibly.

In some possible implementations, the second sliding block may alternatively be set as an arc-shaped sliding block, and the second sliding rail is adaptively set as an arc-shaped sliding rail. This can reduce a risk of detaching the second sliding block from the second sliding rail, and help improve reliability of matching between the second sliding block and the second sliding rail; and can help improve smoothness of sliding the second sliding block along the second sliding rail, effectively reduce interference of another structure on the hinge mechanism on motion of the swing arm, and help increase a wall thickness of the swing arm. In another possible implementation of this application, when the hinge mechanism is in an unfolded state, an axis center of the arc-shaped sliding rail may be located on a side, of the arc-shaped sliding rail, facing the base, so that the second sliding rail is disposed flexibly. It may be understood that the second sliding block herein may alternatively be another shape that adapts to the arc-shaped sliding rail, for example, may be a sliding block in an overall arc-shaped form with a hollow and spacing design in a middle part, or may be some special-shaped sliding blocks, as long as the sliding block can fit the sliding rail in the arc-shaped form for sliding.

In this application, the main hinge module may further include a drive connecting rod. The drive connecting rod is disposed between the first support arm and the swing arm. The drive connecting rod includes a first connection part and a second connection part, the first connection part is rotatably connected to the support arm through a first connecting rod, and the second connection part is rotatably connected to the swing arm through a second connecting rod. Axes of the first connecting rod and the second connecting rod do not overlap. This can effectively improve a combination degree between the first support arm and the swing arm and the corresponding sliding grooves, improve motion consistency between the first support arm and the swing arm, and enable motion of the first support arm and the swing arm to be smoother. In addition, when the electronic device in which the hinge mechanism is used falls in the folded state, the first support arm, the swing arm, and the drive connecting rod can jointly support a housing of the electronic device. This can avoid causing a large instantaneous displacement of the housing relative to the hinge mechanism, and improve reliability of the overall structure of the electronic device.

In addition to the foregoing disposing manner of the drive connecting rod, in another possible implementation, the drive connecting rod is located between the first support arm and the swing arm, the drive connecting rod includes a first connection part and a second connection part, the first connection part is slidably connected to the swing arm through a first connecting rod, and the second connection part is fastened to the first support arm.

To implement a slidable connection between the first connecting rod and the swing arm, a guiding slot may be disposed at an end part, of the swing arm, facing the first support arm, so that the first connecting rod can be inserted into the guiding slot and can slide along a slot surface of the guiding slot. In addition, the drive connecting rod and the first support arm may be an integrated structure, so as to simplify a structure of the main hinge module.

In the disposing manner provided in this implementation, the guiding slot can be appropriately designed for the drive connecting rod, to improve a combination degree between the first support arm and the swing arm and the corresponding sliding grooves, improve motion consistency between the first support arm and the swing arm, and enable motion of the first support arm and the swing arm to be smoother. In addition, when the electronic device in which the hinge mechanism is used falls in the folded state, the first support arm, the swing arm, and the drive connecting rod can jointly support a housing corresponding to the electronic device. This can avoid causing a large instantaneous displacement of the housing relative to the hinge mechanism, and improve reliability of the overall structure of the electronic device.

In addition, to avoid over-constraint on motion of the first support arm and the swing arm, in a possible implementation of this application, when the second sliding groove of the housing mounting bracket is provided with a second sliding rail, and the swing arm may be provided with a second sliding block that can slide along the second sliding rail, the second sliding block is in clearance fit with the second sliding rail, so as to increase freedom of motion of the swing arm.

When the second sliding block is in clearance fit with the second sliding rail, a shape of the second sliding block may match a shape of the second sliding rail. For example, when the second sliding rail is a rectangular sliding rail, the second sliding block may be set as a rectangular sliding block. Alternatively, the second sliding block may be set as a pin shaft, so as to simplify a structure of the second sliding block.

In another possible implementation of this application, the swing arm may be rotatably connected to the housing mounting bracket. In this solution, a connecting rod-sliding block mechanism is formed between the first support arm and the swing arm. In a process in which the electronic device changes from the folded state to an unfolded state, a rotation angle of the first support arm may be 90°, but a rotation angle of the swing arm needs to be greater than 90°.

To avoid rotation of the swing arm, in this implementation of this application, the hinge mechanism may further include an end cover and a rotation member. The end cover has an accommodation part, and the base may be disposed in the accommodation part. In addition, one end of the rotation member presses against a bottom surface, of the end cover, facing the base, and the other end of the rotation member is rotatably connected to the base. In addition, when the first rotating component and the second rotating component rotate away from each other, the swing arm can rotate around the base to drive the end cover to rotate around the base, and a rotation direction of the end cover is the same as a rotation direction of the swing arm, so that the end cover can avoid the swing arm. This can avoid a thinning design of a local structure of the swing arm, and ensure a structural strength of the swing arm; and further avoid thinning designs of other parts of the hinge mechanism and components in the electronic device in which the hinge mechanism is disposed, and enable the overall structure of the electronic device to be more stable.

In addition, the hinge mechanism may further include a resetting element, and the rotation member may be rotatably connected to the base via the resetting element. When the first support arm and the second support arm rotate towards each other, the swing arm rotates around the base. In this case, the rotation member may rotate around the base under the action of the resetting element, to drive the end cover to rotate, and the rotation direction of the end cover is the same as the rotation direction of the swing arm. This ensures integrity of an appearance of the hinge mechanism in the rotation process of the hinge mechanism.

In a possible implementation of this application, to implement a rotatable connection between the second support plate and the base, the base may be provided with a second arc-shaped slot, and an end, of the second support plate, rotatably connected to the base is provided with a second arc-shaped rotation block. In this way, the second arc-shaped rotation block can be accommodated in the second arc-shaped slot, and the second arc-shaped rotation block rotates along an arc-shaped surface of the second arc-shaped slot, so that the second support plate is rotatably connected to the base. The second support plate is rotatably connected to the base through a virtual shaft, and this can effectively reduce space occupied by the second support plate on the base and facilitate a miniaturization design of the hinge mechanism. In another possible implementation of this application, the second support plate may alternatively be rotatably connected to the base via a physical rotating shaft, so as to improve reliability of the connection between the second support plate and the base.

In addition, the second rotating component further includes a second support arm, and the second support arm may be rotatably connected to the base. The second support plate may be rotatably connected to the second support arm through a connecting rod component, and the rotating component may include at least two connecting rod pieces hinged with each other. This can adjust a motion track of the second support plate by appropriately designing the connecting rod component.

In some other possible implementations of this application, the second support plate may alternatively be provided with a second guiding part, and the second guiding part has a second track slot. In addition, the second support arm may be provided with a second guiding structure, and the second guiding structure may be inserted into the second track slot and can slide along the second track slot. This can adjust a motion track of the second support plate by appropriately designing the second track slot.

In a possible implementation of this application, the main hinge module may further include a synchronization component, the synchronization component may include a first drive gear disposed at an end part of the first support arm and a second drive gear disposed at an end part of the second support arm, and the first drive gear and the second drive gear are engaged. In this way, when one support arm rotates around the base, the other support arm can be driven to rotate synchronously at a same angle in a direction towards or away from each other.

In addition, because the first support arm is slidably connected to the housing mounting bracket, the second support arm may be rotatably connected to the second support plate. This can implement synchronous rotation of the housing mounting bracket and the second support plate through synchronous rotation of the two support arms. In addition, in this application, the housing mounting bracket may be fastened to one housing of the electronic device, and the second support plate may be fastened to the other housing of the electronic device. This can implement synchronous rotation of the two housings of the electronic device, prevent an instantaneous acting force from being applied to the flexible display fastened to the two housings, and help improve reliability of the flexible display.

In addition, the synchronization component may further include an even number of driven gears, and the even number of driven gears may be disposed between two drive gears, so that the two drive gears implement synchronous rotation via the even number of driven gears. This helps improve stability of motion of the synchronization component, and improves reliability of synchronous rotation of the two support arms.

In addition to the foregoing structure, a damping component may be disposed in the main hinge module. The damping component may include an elastic member and a conjoined cam, and the conjoined cam may be located between the elastic member and the first support arm and the second support arm. In addition, a first cam surface may be disposed at an end part, of the first support arm, facing the conjoined cam, and a second cam surface may be disposed at an end part, of the second support arm, facing the conjoined cam. A third cam surface may be disposed at an end part, of the conjoined cam, facing the first support arm, and a fourth cam surface may be disposed at an end part, of the conjoined cam, facing the second support arm. Under the action of an elastic force of the elastic member, the corresponding first cam surface and the corresponding third cam surface cooperate with each other, and the corresponding third cam surface and the corresponding fourth cam surface cooperate with each other. In this way, in a process in which the two support arms rotate around the base, a damping force can be generated between cam surfaces opposite to each other, and the damping force blocks rotation of the support arms. The damping force can be transferred to the housing mounting bracket via the first support arm, and transferred to the second support plate via the second support arm, so that the housing mounting bracket and the second support plate respectively act on the housings of the electronic device. This can avoid false unfolding and folding of the electronic device, and can implement suspension of the two housings at a specified position. In addition, a user may have an obvious feeling in a process of unfolding or folding the electronic device. This helps improve user experience.

According to a second aspect, this application further provides an electronic device. The electronic device includes a first housing, a second housing, a flexible display, and the hinge mechanism in the first aspect. The first housing and the second housing are separately disposed on two opposite sides of the hinge mechanism, and in the hinge mechanism, the housing mounting bracket is fastened to the first housing, and the second support plate is fastened to the second housing. In addition, the flexible display may continuously cover the first housing, the second housing, and the hinge mechanism, and the flexible display is fastened to the first housing and the second housing.

In the electronic device provided in this application, when the electronic device is in an unfolded state, the two support plates of the hinge mechanism may smoothly support the flexible display. This can ensure that a form of the electronic device in the unfolded state is complete.

In addition, when the hinge mechanism is in a folded state, display accommodating space formed by the hinge mechanism is a tilted triangular interval, so that a bent part, of the flexible display, accommodated in the display accommodating space can be in an asymmetrical water-drop-like form. This helps improve light and shadow of the flexible display, helps reduce a crease width of the flexible display when the flexible display is in an unfolded state, and improves user experience.

In addition, in this application, a motion track of the first support plate can be appropriately designed, so that when the electronic device is in a folded state, enough accommodating space is formed between the two support plates to accommodate the bent part of the flexible display. This can avoid a gap at the hinge mechanism of the electronic device, and ensure that a form of the electronic device in the folded state is complete; and can avoid damage to the flexible display caused by a foreign matter inserted into the electronic device at the hinge mechanism, and implement a thinning design of an overall thickness of the electronic device.

In a possible implementation of this application, the flexible display may be bonded to the first plate surface of the first support plate and the second plate surface of the second support plate. Specifically, the flexible display may be bonded to a partial area of the first plate surface, and the flexible display may be bonded to a partial area of the second plate surface. Therefore, when the electronic device is in the unfolded state, the first housing, the second housing, the first support plate, and the second support plate can all smoothly support the flexible display. In a process in which the electronic device changes from the unfolded state to the folded state, the two support plates can drive the flexible display to rotate. This can effectively avoid deformation of the flexible display, and reduce a risk of damage to the flexible display. In addition, when the electronic device is in the folded state, the flexible display can be fit with the two support plates. This can help improve light and shadow of the flexible display.

According to a third aspect, this application further provides an electronic device. The electronic device is a foldable electronic device. When the electronic device is specifically disposed, the electronic device may include a hinge mechanism, a first housing, a second housing, and a flexible display. The hinge mechanism may be disposed corresponding to a bendable part of the flexible display. When the hinge mechanism is specifically disposed, the hinge mechanism may include a base and a main hinge module, the base includes a bearing surface, and the bearing surface is configured to support the flexible display. The first housing and the second housing are separately disposed on two opposite sides of the hinge mechanism, the first housing has a first support surface, the first support surface is configured to support the flexible display, the second housing has a second support surface, and the second support surface is configured to support the flexible display. In addition, the flexible display continuously covers the first housing, the second housing, and the hinge mechanism, and the flexible display is fastened to the first housing and the second housing.

The main hinge module includes a first rotating component and a second rotating component, the first rotating component and the second rotating component are disposed on two opposite sides of the base, the first rotating component is disposed corresponding to the first housing, and the second rotating component is disposed corresponding to the second housing. The first rotating component includes a first support plate, the first support plate includes a first plate surface, and the first plate surface is configured to support the flexible display. The second rotating component includes a second support plate, the second support plate includes a second plate surface, and the second plate surface is configured to support the flexible display. When the electronic device is in a folded state, an included angle between the first plate surface and the first support surface is greater than an included angle between the second plate surface and the second support surface, to form, between the first plate surface, the second plate surface, and the bearing surface, display accommodating space for accommodating the bendable part of the flexible display.

In the electronic device provided in this application, in the hinge mechanism of the electronic device, the first rotating component and the second rotating component are asymmetrically disposed relative to each other or relative to the base. Such a design can effectively reduce a width of the hinge mechanism, simplify a structure of the hinge mechanism, reduce an overall weight of the electronic device, enable the electronic device to reserve space for disposing other components (for example, a battery or a circuit board), and improve performance of the electronic device. In addition, when the electronic device is in the folded state, the triangular display accommodating space that tilts towards a side of the first support plate can be formed between the first support plate, the second support plate, and the base, so that the bendable part of the flexible display can be accommodated in the display accommodating space, and is in an asymmetrical water-drop-like form. This can prevent the flexible display from being squeezed, effectively reduce a width of a bent area of the flexible display while reducing a risk of damage to the flexible display, and help improve user experience.

In a possible implementation of this application, the second support plate may be a part of the second housing. In another possible implementation of this application, the second support plate may alternatively be an independently disposed structure. In this case, the second support plate may be fastened to the second housing. Regardless of how the second support plate is disposed, when the electronic device is in the folded state, the second plate surface of the second support plate and the second support surface may be located in a same plane. In this way, when the electronic device is in the folded state, the second plate surface and the second support surface can provide a flat support surface for the flexible display, so that the bendable part of the flexible display is in the asymmetrical water-drop-like form.

In a possible implementation of this application, the flexible display may be bonded to the first plate surface of the first support plate and the second plate surface of the second support plate. Specifically, the flexible display may be bonded to a partial area of the first plate surface, and the flexible display may be bonded to a partial area of the second plate surface. Therefore, when the electronic device is in an unfolded state, the first housing, the second housing, the first support plate, and the second support plate can all smoothly support the flexible display. In a process in which the electronic device changes from the unfolded state to the folded state, the two support plates can drive the flexible display to rotate. This can effectively avoid deformation of the flexible display, and reduce a risk of damage to the flexible display. In addition, when the electronic device is in the folded state, the flexible display can be fit with the two support plates. This can help improve light and shadow of the flexible display.

In a possible implementation of this application, the first rotating component further includes a first support arm and a housing mounting bracket, the first support arm is rotatably connected to the base, the first support arm is slidably connected to the housing mounting bracket, and the first support plate is rotatably connected to the housing mounting bracket. In addition, the second support plate is rotatably connected to the base. In this way, when the hinge mechanism is in an unfolded state, the first plate surface of the first support plate, the second plate surface of the second support plate, and the bearing surface of the base can all smoothly support the flexible display. In addition, when the first rotating component and the second rotating component rotate towards each other, the first support plate rotates around the housing mounting bracket, and an end, of the first support plate, close to the base moves in a direction away from the base. However, in a rotation process, the second support plate is always rotatably connected to the base, and rotation axis centers of the first support plate and the second support plate do not overlap. This can form, between the first support plate and the second support plate, the triangular display accommodating space that tilts towards the side of the first support plate.

To implement rotation of the first support plate around the housing mounting bracket, a rotating slot can be disposed on the housing mounting bracket, and a rotating part is disposed on the first support plate. In this way, the rotating part can be installed in the rotating slot, and the rotating part can rotate along a slot surface of the rotating slot.

In this application, the first rotating component may further include a swing arm, the swing arm may rotatably be connected to the base, and a rotation axis of the first support arm is parallel to but does not overlap a rotation axis of the swing arm. Therefore, phase difference motion effect between the swing arm and the first support arm can be implemented, so that in the rotation process of the hinge mechanism, the first rotating component performs a telescopic motion relative to the base, and the hinge mechanism can adapt to a length of the flexible display. This avoids pulling or squeezing the flexible display, reduces a risk of damage to the flexible display, and prolongs a service life of the flexible display.

In addition, in a process in which the second rotating component rotates around the base, a distance between the second rotating component relative to the base does not extend. This can have a simple structure design of a second rotating component side of the hinge mechanism, occupy small space, and help reduce a volume of the entire hinge mechanism. In this case, the electronic device in which the hinge mechanism is used can reserve more space for disposing components such as a battery or a circuit board. This helps improve performance of the electronic device.

It can be learned from the foregoing description of the hinge mechanism that when the first rotating component and the second rotating component rotate towards each other, the first support plate can rotate around the housing mounting bracket. This can form the display accommodating space between the first support plate and the second support plate. To form, between the two support plates, the display accommodating space that meets a bent requirement of the flexible display, a motion track of the first support plate can be appropriately designed. In a possible implementation of this application, the first support plate may be slidably connected to the first support arm, to drive the first support plate to rotate around the housing mounting bracket by rotating the first support arm around the base. In addition, the first support plate may be slidably connected to the swing arm, to drive the first support plate to rotate around the housing mounting bracket by rotating the swing arm around the base. Alternatively, the first support plate may be slidably connected to both the first support arm and the swing arm, to drive the first support plate to rotate around the housing mounting bracket by rotating the first support arm and the swing arm around the base.

During specific implementation, when the first support plate is slidably connected to the first support arm, a first guiding part may be disposed on the first support plate, and the first guiding part is provided with a first track slot. In addition, a first guiding structure may be disposed on the first support arm, and the first guiding structure may be inserted into the first track slot and can slide along the first track slot. Therefore, in a process in which the swing arm and the first support arm rotate around the base, the first support plate is driven to rotate around the housing mounting bracket, and a motion track of the first support plate is adjusted by sliding the first guiding structure in the first track slot. This forms, between the two support plates, the display accommodating space that meets a screen-accommodating requirement.

In addition/Alternatively, when the first support plate is slidably connected to the swing arm, a first guiding structure may be disposed on the swing arm, and the first guiding structure may be inserted into the first track slot and can slide along the first track slot. Therefore, in a process in which the swing arm rotates around the base, the first support plate is driven to rotate around the housing mounting bracket, and a motion track of the first support plate is adjusted by sliding the first guiding structure in the first track slot. This forms, between the two support plates, the display accommodating space that meets a screen-accommodating requirement.

In this application, the swing arm is rotatably connected to the base in multiple manners. For example, a first arc-shaped slot may be disposed on the base, and a first arc-shaped rotation block is disposed at an end, of the swing arm, rotatably connected to the base. In this way, the first arc-shaped rotation block can be accommodated in the first arc-shaped slot, and the first arc-shaped rotation block rotates along an arc-shaped surface of the first arc-shaped slot, so that the swing arm is rotatably connected to the base. The swing arm is rotatably connected to the base through a virtual shaft, and this can effectively reduce space occupied by the swing arm on the base and facilitate a miniaturization design of the hinge mechanism.

In addition, the hinge mechanism may further include a cover plate, and the cover plate may cover the base, to form accommodating space between the base and the cover plate. In addition, an arc-shaped protrusion may be disposed on a surface, of the cover plate, facing the first arc-shaped slot, and the first arc-shaped rotation block of the swing arm may be inserted between the arc-shaped protrusion and the first arc-shaped slot. This limits the first arc-shaped rotation block on the base, prevents the first arc-shaped rotation block from falling off from the base, and improves reliability of a connection between the swing arm and the base. In a possible implementation of this application, the first arc-shaped slot may alternatively be of an integrated channel structure directly disposed on the base, and can effectively simplify a structure of the base while ensuring reliability of a connection between the first arc-shaped rotation block and the first arc-shaped slot.

In a possible implementation of this application, the swing arm is slidably connected to the housing mounting bracket. A first sliding groove extending in a first direction and a second sliding groove extending in a second direction may be disposed on the housing mounting bracket, the first support arm can slide in the first sliding groove, and the swing arm can slide in the second sliding groove. In addition, a projection along the first direction in a first cross section is not parallel to a projection along the second direction in the first cross section. The first cross section is a reference plane perpendicular to the rotation axis of the first support arm and the rotation axis of the swing arm. This can adjust, by appropriately designing disposing directions of the first sliding groove and the second sliding groove, angles at which the first support arm and the swing arm rotate relative to the base. For example, the rotation angles of the first support arm and the swing arm may be not greater than 90°. Therefore, the angles at which a first swing arm and a second swing arm rotate relative to the base can be small, so that another structure on the hinge mechanism can be prevented from avoiding rotation of the swing arm. This can help increase a wall thickness of a local structure of the swing arm, and improve structural reliability of the swing arm. In addition, when being used in the electronic device, the hinge mechanism can effectively avoid a case in which a component in the electronic device is thinning designed, to avoid rotation of the swing arm. This can improve reliability of an overall structure of the electronic device; and can reduce a risk of squeezing the flexible display of the electronic device caused by rotation of the swing arm, reduce the risk of damage to the flexible display, and prolong the service life of the flexible display.

In a possible implementation of this application, a first sliding rail may be disposed on a slot wall of the first sliding groove of the housing mounting bracket, and a first sliding block may be disposed on the first support arm. The first sliding block may be clamped on the first sliding rail, and may slide along the first sliding rail. This can prevent the first support arm from falling off from the housing mounting bracket. The first sliding rail can provide guidance for sliding of the first support arm, and this improves reliability of sliding the first support arm along the housing mounting bracket.

Similarly, a second sliding rail may be disposed on a slot wall of the second sliding groove of the housing mounting bracket, and a second sliding block is disposed on the swing arm. The second sliding block may be clamped on the second sliding rail, and may slide along the second sliding rail. This can prevent the swing arm from falling off from the housing mounting bracket. The second sliding rail can provide guidance for sliding of the swing arm, and this improves reliability of sliding the swing arm along the housing mounting bracket.

In addition, in this application, when the second sliding block is specifically disposed, the second sliding block may be a straight-line sliding block. In this case, the second sliding rail may be adaptively disposed as a straight-line sliding rail. This can effectively simplify a processing process of the second sliding block and the second sliding rail. It may be understood that the second sliding block herein may alternatively be another shape that adapts to the straight-line sliding rail, for example, may be a sliding block in an overall straight-line form with a hollow and spacing design in a middle part, or may be some special-shaped sliding blocks, as long as the sliding block can fit the sliding rail in the straight-line form for sliding.

In a possible implementation of this application, the housing mounting bracket includes a first surface, and the first surface is a side surface, of the housing mounting bracket, facing the flexible display. In this case, when the hinge mechanism is in the unfolded state, the straight-line sliding rail can extend from an opening to a direction of the base. This can help improve smoothness of sliding the second sliding block along the second sliding rail, effectively reduce interference of another structure on the hinge mechanism on motion of the swing arm, and help increase a wall thickness of the swing arm. In another possible implementation of this application, the straight-line sliding rail may alternatively extend from an opening to a direction away from the base; or the straight-line sliding rail may also extend from an opening to a direction perpendicular to the second surface, so that the second sliding rail is disposed flexibly. It may be understood that the second sliding block herein may alternatively be another shape that adapts to the arc-shaped sliding rail, for example, may be a sliding block in an overall arc-shaped form with a hollow and spacing design in a middle part, or may be some special-shaped sliding blocks, as long as the sliding block can fit the sliding rail in the arc-shaped form for sliding.

In some possible implementations, the second sliding block may alternatively be set as an arc-shaped sliding block, and the second sliding rail is adaptively set as an arc-shaped sliding rail. This can reduce a risk of detaching the second sliding block from the second sliding rail, and help improve reliability of matching between the second sliding block and the second sliding rail; and can help improve smoothness of sliding the second sliding block along the second sliding rail, effectively reduce interference of another structure on the hinge mechanism on motion of the swing arm, and help increase a wall thickness of the swing arm. In another possible implementation of this application, when the hinge mechanism is in an unfolded state, an axis center of the arc-shaped sliding rail may be located on a side, of the arc-shaped sliding rail, facing the base, so that the second sliding rail is disposed flexibly.

In this application, the main hinge module may further include a drive connecting rod. The drive connecting rod is disposed between the first support arm and the swing arm. The drive connecting rod includes a first connection part and a second connection part, the first connection part is rotatably connected to the support arm through a first connecting rod, and the second connection part is rotatably connected to the swing arm through a second connecting rod. Axes of the first connecting rod and the second connecting rod do not overlap. This can effectively improve a combination degree between the first support arm and the swing arm and the corresponding sliding grooves, improve motion consistency between the first support arm and the swing arm, and enable motion of the first support arm and the swing arm to be smoother. In addition, when the electronic device in which the hinge mechanism is used falls in the folded state, the first support arm, the swing arm, and the drive connecting rod can jointly support a housing of the electronic device. This can avoid causing a large instantaneous displacement of the housing relative to the hinge mechanism, and improve reliability of the overall structure of the electronic device.

In addition to the foregoing disposing manner of the drive connecting rod, in another possible implementation, the drive connecting rod is located between the first support arm and the swing arm, the drive connecting rod includes a first connection part and a second connection part, the first connection part is slidably connected to the swing arm through a first connecting rod, and the second connection part is fastened to the first support arm.

To implement a slidable connection between the first connecting rod and the swing arm, a guiding slot may be disposed at an end part, of the swing arm, facing the first support arm, so that the first connecting rod can be inserted into the guiding slot and can slide along a slot surface of the guiding slot. In addition, the drive connecting rod and the first support arm may be an integrated structure, so as to simplify a structure of the main hinge module.

In the disposing manner provided in this implementation, the guiding slot can be appropriately designed for the drive connecting rod, to improve a combination degree between the first support arm and the swing arm and the corresponding sliding grooves, improve motion consistency between the first support arm and the swing arm, and enable motion of the first support arm and the swing arm to be smoother. In addition, when the electronic device in which the hinge mechanism is used falls in the folded state, the first support arm, the swing arm, and the drive connecting rod can jointly support a housing corresponding to the electronic device. This can avoid causing a large instantaneous displacement of the housing relative to the hinge mechanism, and improve reliability of the overall structure of the electronic device.

In addition, to avoid over-constraint on motion of the first support arm and the swing arm, in a possible implementation of this application, when the second sliding groove of the housing mounting bracket is provided with a second sliding rail, and the swing arm may be provided with a second sliding block that can slide along the second sliding rail, the second sliding block is in clearance fit with the second sliding rail, so as to increase freedom of motion of the swing arm.

When the second sliding block is in clearance fit with the second sliding rail, a shape of the second sliding block may match a shape of the second sliding rail. For example, when the second sliding rail is a rectangular sliding rail, the second sliding block may be set as a rectangular sliding block. Alternatively, the second sliding block may be set as a pin shaft, so as to simplify a structure of the second sliding block.

In another possible implementation of this application, the swing arm may be rotatably connected to the housing mounting bracket. In this solution, a connecting rod-sliding block mechanism is formed between the first support arm and the swing arm. In a process in which the electronic device changes from the folded state to an unfolded state, a rotation angle of the first support arm may be 90°, but a rotation angle of the swing arm needs to be greater than 90°.

To avoid rotation of the swing arm, in this implementation of this application, the hinge mechanism may further include an end cover and a rotation member. The end cover has an accommodation part, and the base may be disposed in the accommodation part. In addition, one end of the rotation member presses against a bottom surface, of the end cover, facing the base, and the other end of the rotation member is rotatably connected to the base. In addition, when the first rotating component and the second rotating component rotate away from each other, the swing arm can rotate around the base to drive the end cover to rotate around the base, and a rotation direction of the end cover is the same as a rotation direction of the swing arm, so that the end cover can avoid the swing arm. This can avoid a thinning design of a local structure of the swing arm, and ensure a structural strength of the swing arm; and further avoid thinning designs of other parts of the hinge mechanism and components in the electronic device in which the hinge mechanism is disposed, and enable the overall structure of the electronic device to be more stable.

In addition, the hinge mechanism may further include a resetting element, and the rotation member may be rotatably connected to the base via the resetting element. When the first support arm and the second support arm rotate towards each other, the swing arm rotates around the base. In this case, the rotation member may rotate around the base under the action of the resetting element, to drive the end cover to rotate, and the rotation direction of the end cover is the same as the rotation direction of the swing arm. This ensures integrity of an appearance of the hinge mechanism in the rotation process of the hinge mechanism.

In a possible implementation of this application, to implement a rotatable connection between the second support plate and the base, the base may be provided with a second arc-shaped slot, and an end, of the second support plate, rotatably connected to the base is provided with a second arc-shaped rotation block. In this way, the second arc-shaped rotation block can be accommodated in the second arc-shaped slot, and the second arc-shaped rotation block rotates along an arc-shaped surface of the second arc-shaped slot, so that the second support plate is rotatably connected to the base. The second support plate is rotatably connected to the base through a virtual shaft, and this can effectively reduce space occupied by the second support plate on the base and facilitate a miniaturization design of the hinge mechanism. In another possible implementation of this application, the second support plate may alternatively be rotatably connected to the base via a physical rotating shaft, so as to improve reliability of the connection between the second support plate and the base.

In addition, the second rotating component further includes a second support arm, and the second support arm may be rotatably connected to the base. The second support plate may be rotatably connected to the second support arm through a connecting rod component, and the rotating component may include at least two connecting rod pieces hinged with each other. This can adjust a motion track of the second support plate by appropriately designing the connecting rod component.

In some other possible implementations of this application, the second support plate may alternatively be provided with a second guiding part, and the second guiding part has a second track slot. In addition, the second support arm may be provided with a second guiding structure, and the second guiding structure may be inserted into the second track slot and can slide along the second track slot. This can adjust a motion track of the second support plate by appropriately designing the second track slot.

In a possible implementation of this application, the main hinge module may further include a synchronization component, the synchronization component may include a first drive gear disposed at an end part of the first support arm and a second drive gear disposed at an end part of the second support arm, and the first drive gear and the second drive gear are engaged. In this way, when one support arm rotates around the base, the other support arm can be driven to rotate synchronously at a same angle in a direction towards or away from each other.

In addition, because the first support arm is slidably connected to the housing mounting bracket, the second support arm may be rotatably connected to the second support plate. This can implement synchronous rotation of the housing mounting bracket and the second support plate through synchronous rotation of the two support arms. In addition, in this application, the housing mounting bracket may be fastened to one housing of the electronic device, and the second support plate may be fastened to the other housing of the electronic device. This can implement synchronous rotation of the two housings of the electronic device, prevent an instantaneous acting force from being applied to the flexible display fastened to the two housings, and help improve reliability of the flexible display.

In addition, the synchronization component may further include an even number of driven gears, and the even number of driven gears may be disposed between two drive gears, so that the two drive gears implement synchronous rotation via the even number of driven gears. This helps improve stability of motion of the synchronization component, and improves reliability of synchronous rotation of the two support arms.

In addition to the foregoing structure, a damping component may be disposed in the main hinge module. The damping component may include an elastic member and a conjoined cam, and the conjoined cam may be located between the elastic member and the first support arm and the second support arm. In addition, a first cam surface may be disposed at an end part, of the first support arm, facing the conjoined cam, and a second cam surface may be disposed at an end part, of the second support arm, facing the conjoined cam. A third cam surface may be disposed at an end part, of the conjoined cam, facing the first support arm, and a fourth cam surface may be disposed at an end part, of the conjoined cam, facing the second support arm. Under the action of an elastic force of the elastic member, the corresponding first cam surface and the corresponding third cam surface cooperate with each other, and the corresponding third cam surface and the corresponding fourth cam surface cooperate with each other. In this way, in a process in which the two support arms rotate around the base, a damping force can be generated between cam surfaces opposite to each other, and the damping force blocks rotation of the support arms. The damping force can be transferred to the housing mounting bracket via the first support arm, and transferred to the second support plate via the second support arm, so that the housing mounting bracket and the second support plate respectively act on the housings of the electronic device. This can avoid false unfolding and folding of the electronic device, and can implement suspension of the two housings at a specified position. In addition, a user may have an obvious feeling in a process of unfolding or folding the electronic device. This helps improve user experience.

### BRIEF DESCRIPTION OF DRAWINGS

FIG. 1 is a schematic diagram of a structure of an electronic device in a folded state according to an embodiment of this application;
FIG. 2 is a schematic diagram of a structure of an electronic device in an unfolded state according to an embodiment of this application;
FIG. 3 is a schematic diagram of a structure of display accommodating space formed by a hinge mechanism in the conventional technology according to an embodiment of this application;
FIG. 4 is a schematic diagram of an exploded structure of an electronic device according to an embodiment of this application;
FIG. 5a is a schematic diagram of an exploded structure of a hinge mechanism according to an embodiment of this application;
FIG. 5b is a block diagram of a structure of a hinge mechanism shown in FIG. 4 in a folded state;
FIG. 6 is a schematic diagram of a structure of a main hinge module according to an embodiment of this application;
FIG. 7 is a schematic diagram of a structure of a swing arm according to an embodiment of this application;
FIG. 8 is a schematic diagram of a partial structure of a main hinge module according to an embodiment of this application;
FIG. 9 is a schematic diagram of a structure of a housing mounting bracket according to an embodiment of this application;
FIG. 10a is a schematic diagram of a structure of a hinge mechanism in an unfolded state according to an embodiment of this application;
FIG. 10b is a schematic diagram of a first section according to an embodiment of this application;
FIG. 10c is a schematic diagram of a structure of a hinge mechanism in an intermediate state according to an embodiment of this application;
FIG. 10d is a schematic diagram of a structure of a hinge mechanism in a folded state according to an embodiment of this application;
FIG. 11 is a diagram of a principle of a mechanism in which a first support arm and a swing arm slide relative to a housing mounting bracket according to an embodiment of this application;
FIG. 12a is a schematic diagram of a structure of a swing arm according to another embodiment of this application;
FIG. 12b is a schematic diagram of a first section according to another embodiment of this application;
FIG. 12c is a schematic diagram of a first section according to another embodiment of this application;
FIG. 12d is a schematic diagram of a first section according to another embodiment of this application;
FIG. 13a is a schematic diagram of a connection structure of a support arm and a swing arm according to an embodiment of this application;
FIG. 13b is a schematic diagram of a structure of a drive connecting rod according to an embodiment of this application;
FIG. 13c is a schematic diagram of a structure of a first support arm according to an embodiment of this application;
FIG. 14 is a sectional view at a position B-B in FIG. 13a;
FIG. 15 is a sectional view at a position C-C in FIG. 13a;
FIG. 16 is a schematic diagram of a structure of a swing arm according to another embodiment of this application;
FIG. 17a is a schematic diagram of a connection structure of a first support arm and a swing arm according to another embodiment of this application;
FIG. 17b is a schematic diagram of a structure of a swing arm according to another embodiment of this application;
FIG. 17c is a schematic diagram of a connection structure of a drive connecting rod and a first support arm according to an embodiment of this application;
FIG. 18 is a schematic diagram of a structure of a support plate according to an embodiment of this application;
FIG. 19 is a schematic diagram of a structure of supporting a flexible display by support plates according to an embodiment of this application;
FIG. 20 is a sectional view of a hinge mechanism according to an embodiment of this application;
FIG. 21 is a schematic diagram of a structure of a second support plate according to an embodiment of this application;
FIG. 22 is a schematic diagram of a structure of a hinge mechanism according to another embodiment of this application;
FIG. 23 is a sectional view of a hinge mechanism in a folded state according to an embodiment of this application;
FIG. 24 is a sectional view at a position D-D in FIG. 6;
FIG. 25 is a schematic diagram of a structure of a hinge mechanism according to another embodiment of this application;
FIG. 26 is a schematic diagram of a structure of a swing arm according to another embodiment of this application;
FIG. 27 is a schematic diagram of a structure of a housing mounting bracket according to another embodiment of this application;
FIG. 28 is a diagram of a principle of a mechanism of a first support arm and a swing arm according to another embodiment of this application;
FIG. 29 is an exploded view of a hinge mechanism according to another embodiment of this application;
FIG. 30 is a sectional view at a position, of a hinge mechanism, at which a rotation member is disposed according to an embodiment of this application;
FIG. 31 is a sectional view at a swing arm when a hinge mechanism is in an unfolded state according to an embodiment of this application;
FIG. 32 is a schematic diagram of a structure of a hinge mechanism in an intermediate state according to an embodiment of this application;
FIG. 33 is a schematic diagram of a structure of a hinge mechanism in a folded state according to an embodiment of this application; and
FIG. 34 is a sectional view of a hinge mechanism according to another embodiment of this application.

### Reference numerals:

1: hinge mechanism; 101: main hinge module; 101a: first rotating component; 101b: second rotating component;
1012a: first support arm; 10121: first sliding block; 1012b: second support arm; 10123: first mounting hole;
1013: swing arm; 10131: first arc-shaped rotation block; 10132: second sliding block; 10133: first guiding structure;
10134: second mounting hole; 10135: guiding slot; 10136: third mounting hole;
1014: cover plate; 10141: arc-shaped protrusion;
1015: housing mounting bracket; 1015a: first surface; 1015b: second surface; 10151: first sliding groove;
101511: first sliding rail; 10152: second sliding groove; 101521: second sliding rail; 10153: rotating slot; 10154: mounting part;
1016: drive connecting rod; 10161: first connection part; 10162: second connection part; 10163: first connecting rod;
10164: second connecting rod;
1017: synchronization component; 10171a: first drive gear; 10171b: second drive gear; 10172: driven gear;
10173: middle shaft;
1018: damping component; 10181: elastic member; 10182: conjoined cam; 10183: stopper; 10184: circlip;
1019: rotation member; 1020: base; 1020a: bearing surface; 10201a: first pin shaft; 10201b: second pin shaft;
10202: damping support; 10203: first arc-shaped slot; 10204: second arc-shaped slot;
102: first support plate; 102a: first plate surface; 102b: third plate surface; 1021: rotating part; 1022: first guiding part;
10221: first track slot; 103: second support plate; 103a: second plate surface; 103b: fourth plate surface;
1031: second arc-shaped rotation block;
104: connecting rod component; 105: display accommodating space; 106: end cover;
2: first housing; 2a: first appearance surface; 2b: first support surface; 201: first groove;
3: second housing; 3a: second appearance surface; 3b: second support surface; 301: second groove; and
4: flexible display.

### DESCRIPTION OF EMBODIMENTS

To make the objectives, technical solutions, and advantages of this application clearer, the following further describes this application in detail with reference to the accompanying drawings.

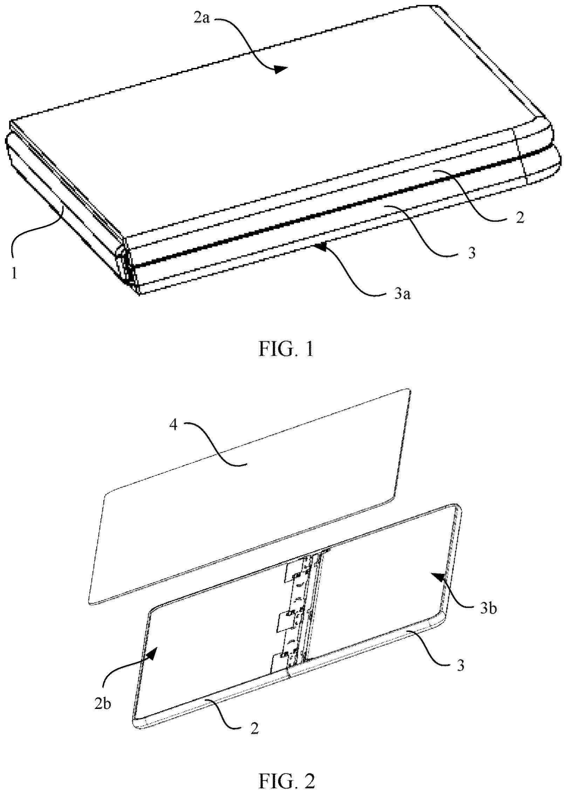

For ease of understanding a hinge mechanism provided in embodiments of this application, the following first describes an application scenario of the hinge mechanism. The hinge mechanism is used in, but is not limited to, a foldable electronic device such as a mobile phone, a palmtop computer (personal digital assistant, PDA), a notebook computer, or a tablet computer. When the hinge mechanism provided in embodiments of this application is used in an electronic device, refer to FIG. 1. FIG. 1 is a schematic diagram of a structure of an electronic device according to an embodiment of this application. In addition to a hinge mechanism 1, the electronic device may further include two housings and a flexible display. For ease of description, the two housings may be respectively named a first housing 2 and a second housing 3. The first housing 2 and the second housing 3 are located on two sides of the hinge mechanism 1, and can rotate around the hinge mechanism 1. When the electronic device is used, the electronic device may be folded and unfolded in different use scenarios. The electronic device provided in this application may be an inward-folded electronic device. In the embodiment shown in FIG. 1, the electronic device is in a folded state, and FIG. 1 shows a relative position relationship between the hinge mechanism 1 and the two housings when the electronic device is in the folded state. In this case, a surface of the hinge mechanism 1, a first surface of the first housing 2, and a first surface of the second housing 3 may be jointly used as an appearance surface of the electronic device. The first surface of the first housing 2 is a surface, of the first housing 2, away from the flexible display, and the first surface of the second housing 3 is a surface, of the second housing 3, away from the flexible display 4. Therefore, in the following embodiments, the first surface of the first housing 2 is denoted as a first appearance surface 2a, and the first surface of the second housing 3 is denoted as a second appearance surface 3a.

In addition, refer to FIG. 2. FIG. 2 is a schematic diagram of the structure of the electronic device in an unfolded state. It should be noted that FIG. 2 shows structures of a second surface side of the first housing 2 and a second surface side of the second housing 3. A second surface of the first housing 2 is a surface, of the first housing 2, configured to support a surface of the flexible display 4, and the second surface of the second housing 3 is a surface, of the second housing 3, configured to support the surface of the flexible display 4. Therefore, in the following embodiments, the second surface of the first housing 2 is denoted as a first support surface 2b, and the second surface of the second housing 3 is denoted as a second support surface 3b.

The flexible display 4 may continuously cover the first support surface 2b of the first housing 2, the second support surface 3b of the second housing 3, and the hinge mechanism 1. The hinge mechanism 1 is disposed corresponding to a bendable part of the flexible display 4. In addition, the flexible display 4 may be fastened to the first support surface 2b of the first housing 2 and the second support surface 3b of the second housing 3, and a connection manner may be but is not limited to bonding. Therefore, when the electronic device is in the unfolded state shown in FIG. 2, the first housing 2 and the second housing 3 may support the flexible display 4.

In a process of relative rotation of the first housing 2 and the second housing 3 from the unfolded state shown in FIG. 2 to the folded state shown in FIG. 1, or from the folded state shown in FIG. 1 to the unfolded state shown in FIG. 2, the flexible display 4 may be bent or flattened with the first housing 2 and the second housing 3.

It may be understood that a process of the electronic device from the unfolded state shown in FIG. 2 to the folded state shown in FIG. 1, or from the folded state shown in FIG. 1 to the unfolded state shown in FIG. 2 is the process of rotating the first housing 2 and the second housing 3 around the hinge mechanism 1. As a key functional component in the foldable electronic device, the hinge mechanism 1 may be disposed corresponding to the foldable part of the flexible display 4. Therefore, the hinge mechanism 1 is important in supporting the foldable part of the flexible display 4 in the unfolded state shown in FIG. 2 and in accommodating the foldable part of the flexible display 4 in the folded state shown in FIG. 1.

For example, when the electronic device is in the folded state shown in FIG. 1, if space formed between the first housing 2, the hinge mechanism 1, and the second housing 3 cannot meet a bent requirement of the flexible display 4, the flexible display 4 may be squeezed or pulled. As a result, after the electronic device performs multiple folding operations, the flexible display 4 is easily damaged.

Currently, when being specifically disposed, the existing hinge mechanism may include a base and two rotating components, and the two rotating components are symmetrically disposed relative to the base. Each rotating component may include a support arm, a swing arm, and a housing mounting bracket. Both the support arm and the swing arm may be rotatably connected to the base, the support arm may be slidably connected to the housing mounting bracket, the swing arm may be rotatably connected to the housing mounting bracket, and the housing mounting bracket may be fastened to a housing of an electronic device. For each rotating component, in a process in which the support arm and the swing arm rotate around the base, because a rotation axis of the support arm and a rotation axis of the swing arm does not overlap, a phase difference motion exists in the process in which the support arm and the swing arm rotate around the base, so that, in the process in which the hinge mechanism changes from the folded state shown in FIG. 1 to the unfolded state shown in FIG. 2 as the electronic device, an extension length of the housing mounting bracket relative to the base increases under the push of the swing arm, and a length of the hinge mechanism increases. However, in the process in which the hinge mechanism changes from the unfolded state shown in FIG. 2 to the folded state shown in FIG. 1, the extension length of the housing mounting bracket relative to the base decreases under the driving of the swing arm, and the length of the hinge mechanism decreases. In a rotation process of the hinge mechanism, the housing mounting bracket performs a telescopic motion relative to the base, so that the hinge mechanism can adapt to a length of the part, of the flexible display, disposed corresponding to the hinge mechanism. This avoids pulling or squeezing the flexible display.

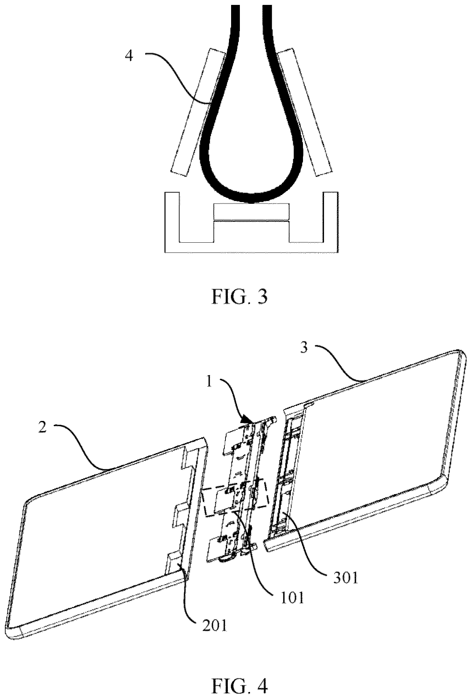

Because the current hinge mechanism is in a symmetric design manner, when the electronic device with the hinge mechanism is in the folded state, display accommodating space that is formed at the hinge mechanism and that is used to accommodate the flexible display 4 is symmetric space shown in FIG. 3. However, a part, of the flexible display 4, accommodated in the display accommodating space is in a bent state to form a symmetric water-drop-like form. This results in a large width of a bent area of the flexible display 4 in a process of changing from an unfolded state to a folded state.

The hinge mechanism provided in this application is intended to resolve the foregoing problem, and to reduce a width of the hinge mechanism, simplify a structure of the hinge mechanism, reduce a weight of the hinge mechanism, reduce space occupied by the hinge mechanism in an entire electronic device, reserve more space for disposing other components, and help improve performance of the electronic device. In addition, the hinge mechanism can form asymmetric display accommodating space to meet a bent requirement of a flexible display. This helps reduce a width of a bent area of the flexible display, avoids deformation of the flexible display, reduces squeezing or pulling stress on the flexible display, prolongs a service life of the flexible display, improves reliability of the electronic device, and improves user experience. To facilitate understanding of the hinge mechanism provided in embodiments of this application, the following describes a specific structure of the hinge mechanism in detail with reference to the accompanying drawings.

It should be noted that terms used in the following embodiments are merely intended to describe specific embodiments, but are not intended to limit this application. The terms "one", "a" and "this" of singular forms used in this specification and the appended claims of this application are also intended to include expressions such as "one or more", unless otherwise specified in the context clearly.

Reference to "an embodiment", "some embodiments", or the like described in this specification indicates that one or more embodiments of this application include a specific feature, structure, or characteristic described with reference to embodiments. Therefore, statements such as "in an embodiment", "in some embodiments", "in some other embodiments", and "in other embodiments" that appear at different places in this specification do not necessarily mean referring to a same embodiment. Instead, the statements mean "one or more but not all of embodiments", unless otherwise specifically emphasized in another manner. The terms "include", "have", and their variants all mean "include but are not limited to", unless otherwise specifically emphasized in another manner.

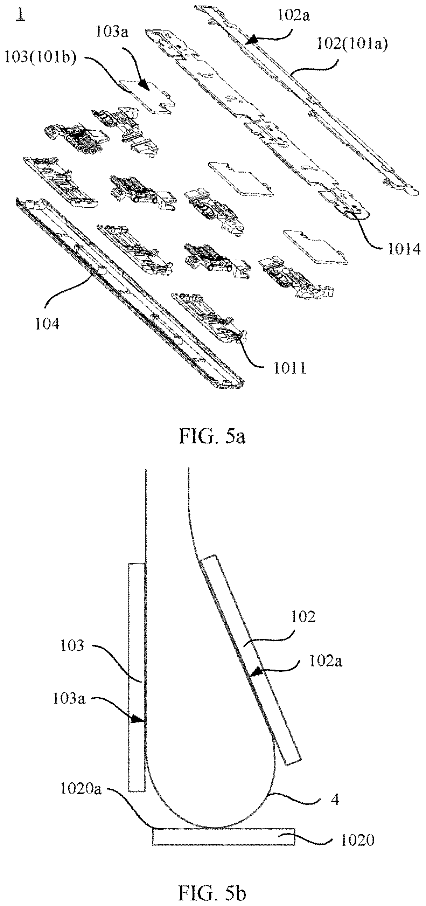

Refer to FIG. 4. FIG. 4 is a schematic diagram of an exploded structure of the electronic device shown in FIG. 2. The flexible display is omitted in FIG. 4. In addition, it can be seen from FIG. 4 that the first housing 2 and the second housing 3 are located on two opposite sides of the hinge mechanism 1. In this application, the hinge mechanism 1 may include one main hinge module 101, or may include multiple main hinge modules 101. For example, refer to FIG. 5a. FIG. 5a is a schematic diagram of an exploded structure of the hinge mechanism 1 shown in FIG. 4. In an embodiment shown in FIG. 5a, the hinge mechanism 1 includes three main hinge modules 101, and the three main hinge modules 101 may be arranged at intervals along a length direction of the hinge mechanism 1. In this application, the length direction of the hinge mechanism 1 is an extension direction of axes of the first housing 2 and the second housing 3 that rotate around the hinge mechanism 1. The first housing 2 and the second housing 3 may be rotatably connected via the multiple main hinge modules 101. This can effectively improve rotation stability of the first housing 2 and the second housing 3 of the electronic device relative to the hinge mechanism 1.

In addition, still refer to FIG. 5a. The hinge mechanism 1 may further include a base 1020. The main hinge module 101 may include a first rotating component 101a and a second rotating component 101b, and the base 1020 may serve as a bearing component of the first rotating component 101a and the second rotating component 101b. The first rotating component 101a and the second rotating component 101b are separately disposed on two opposite sides of the base 1020, and are rotatably connected to the base 1020.

It should be noted that, in a possible embodiment of this application, when there are multiple main hinge modules 101, the first rotating components 101a and the second rotating components 101b of the multiple main hinge modules 101 may all use the same base 1020 as the bearing component. This improves an integration degree of the hinge mechanism 1. In some other possible embodiments of this application, the hinge mechanism 1 may be provided with one base 1020 corresponding to each main hinge module 101, so that the first rotating component 101a and the second rotating component 101b of each main hinge module 101 use the corresponding base 1020 as the bearing component.

Still refer to FIG. 5a. The first rotating component 101a may include a first support plate 102. In addition, the second rotating component 101b may include a second support plate 103. The first support plate 102 includes a first surface and a second surface that are disposed opposite to each other, and the second support plate 103 includes a first surface and a second surface that are disposed opposite to each other. The first surface of the first support plate 102 and the first surface of the second support plate 103 may be used to support the flexible display 4. In embodiments of this application, the first surface of the first support plate 102 may be denoted as a first plate surface 102a, and the first surface of the second support plate 103 may be denoted as a second plate surface 103a.

Refer to FIG. 5b. FIG. 5b is a block diagram of a structure of the hinge mechanism shown in FIG. 4 in the folded state. It can be seen from FIG. 5b that, in the hinge mechanism provided in this application, the base 1020 may include a bearing surface 1020a configured to support the flexible display 4. In addition, an included angle between the first plate surface 102a of the first support plate 102 and the bearing surface 1020a may be less than an included angle between the second plate surface 103a of the second support plate 103 and the bearing surface 1020a, to form, between the first plate surface 102a, the second plate surface 103a, and the bearing surface 1020a, triangular display accommodating space that tilts toward a side of the first support plate 102. The bendable part of the flexible display 4 of the electronic device can be accommodated in the display accommodating space, to be in an asymmetrical water-drop-like form. This can enable the width of the bent area of the flexible display 4 to be small.

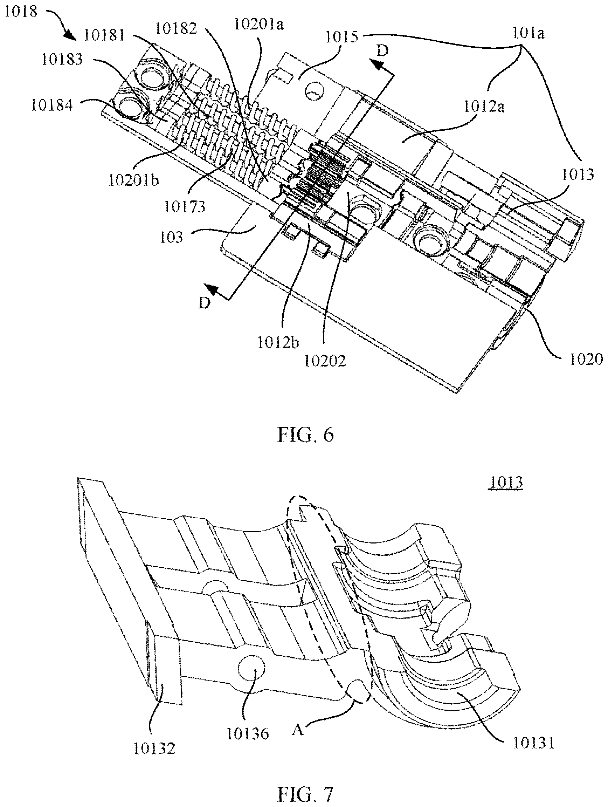

In this application, when the main hinge module 101 is specifically disposed, refer to FIG. 6. FIG. 6 is a schematic diagram of a structure of the main hinge module 101 according to a possible embodiment of this application. The first rotating component 101a may further include a first support arm 1012a, and the first support arm 1012a may be rotatably connected to the base 1020 via a first pin shaft 10201a. During specific implementation, a damping support 10202 may be disposed on the base 1020, and the first pin shaft 10201a may penetrate both the damping support 10202 and the first support arm 1012a. Therefore, the first support arm 1012a is rotatably connected to the damping support 10202 via the first pin shaft 10201a, so that the first rotating component is rotatably connected to the base 1020.

It should be noted that, in this application, the first support arm 1012a may be rotatably connected to the damping support 10202 via the first pin shaft 10201a. In some possible embodiments, the first support arm 1012a may alternatively be rotatably connected to the damping support 10202 through a virtual shaft. The virtual shaft refers to an axis center of a circular arc-shaped structure. Two parts that are rotatably connected may rotate relative to the virtual shaft, and a location of the virtual shaft is fixed as the two parts that are rotatably connected rotate relative to each other. For example, an arc-shaped slot may be disposed on the damping support 10202, and an arc-shaped rotation block is disposed on the first support arm 1012a, so that the first support arm 1012a rotates with the damping support 10202 by sliding the arc-shaped rotation block along a slot surface of the arc-shaped slot.

In this application, the first rotating component 101a may further include a swing arm 1013. The swing arm 1013 and the first support arm 1012a are located on a same side of the base 1020, and the swing arm 1013 is rotatably connected to the base 1020. In a possible embodiment of this application, the swing arm 1013 may be rotatably connected to the base 1020 through a virtual shaft. This can help reduce space occupied by the swing arm 1013 on the base 1020, help reduce a volume of the main hinge module 101, and implement a miniaturization design of the hinge mechanism 1. During specific implementation, refer to FIG. 7. FIG. 7 is a schematic diagram of a structure of the swing arm 1013 according to a possible embodiment of this application. A first arc-shaped rotation block 10131 may be disposed at an end, of the swing arm 1013, configured to connect to the base 1020.

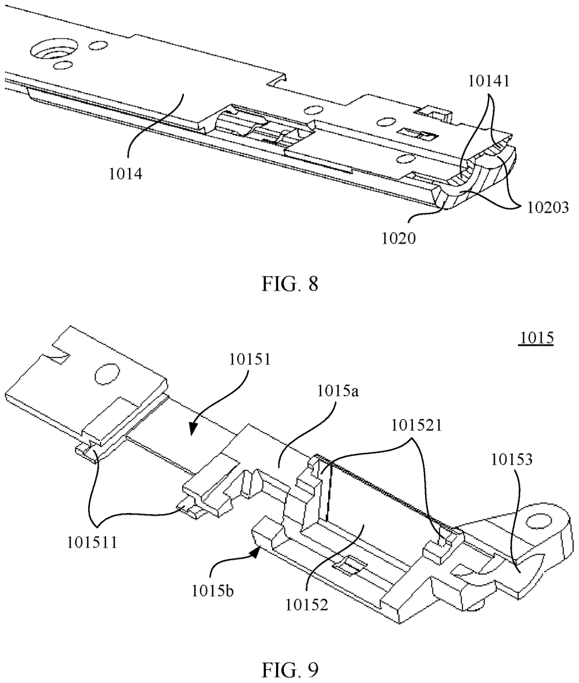

In addition, refer to FIG. 8. FIG. 8 is a schematic diagram of a partial structure of the hinge mechanism. The base 1020 may be provided with a first arc-shaped slot 10203. The first arc-shaped rotation block 10131 of the swing arm 1013 shown in FIG. 7 may be accommodated in the first arc-shaped slot 10203, and may slide along an arc-shaped surface of the first arc-shaped slot 10203, so that the swing arm 1013 rotates around the base 1020. The first swing arm 1013 is rotatably connected to the base 1020 through the virtual shaft. This can help reduce the space occupied by the first swing arm 1013 on the base 1020, help reduce the volume of the main hinge module 101, and implement the miniaturization design of the hinge mechanism 1. It should be noted that in this application, the first arc-shaped rotation block 10131 may be but is not limited to a circular arc-shaped rotation block, and the first arc-shaped slot 10203 may be but is not limited to a circular arc-shaped slot.

Still refer to FIG. 8. The main hinge module 101 may further include a cover plate 1014. The cover plate 1014 may cover the base 1020, to form accommodating space between the cover plate 1014 and the base 1020. In addition, it can be seen from FIG. 8 that an arc-shaped protrusion 10141 may be disposed on a part, of the cover plate 1014, that covers the first arc-shaped slot 10203, and the first arc-shaped rotation block 10131 of the swing arm 1013 shown in FIG. 7 may be inserted between the arc-shaped protrusion 10141 and the first arc-shaped slot 10203. Therefore, the arc-shaped protrusion 10141 limits the first arc-shaped rotation block 10131 of the swing arm 1013 to the first arc-shaped slot 10203 of the base 1020, to reduce a risk that the swing arm 1013 falls off from the base 1020, and improve motion reliability of the swing arm 1013.

In another possible embodiment of this application, the first arc-shaped slot 10203 may alternatively be an integrated channel structure directly disposed on the base 1020. This can implement an integrated design of the base 1020, and improve structural reliability of the hinge mechanism. In addition, a quantity of first arc-shaped slots 10203 may be but is not limited to at least two. The at least two first arc-shaped slots 10203 may be disposed at an interval in a length direction of the base 1020, and the at least two first arc-shaped slots 10203 can limit the first arc-shaped rotation block 10131, to improve reliability of a connection between the first arc-shaped rotation block 10131 and the base 1020.

In some other embodiments of this application, the first swing arm 1013 may be rotatably connected to the base 1020 through a physical shaft. For example, the first swing arm 1013 may be rotatably connected to the base 1020 via a pin shaft. In this way, when the hinge mechanism includes multiple main hinge modules 101, a first swing arm 1013 of at least one main hinge module 101 of the multiple main hinge modules 101 may be rotatably connected to the base 1020 through a virtual shaft, and a first swing arm 1013 of at least one main hinge module 101 may be rotatably connected to the base 1020 through a solid shaft. In this case, first swing arms 1013 of the main hinge components 101 disposed opposite to the flexible display of the electronic device may be rotatably connected to the base 1020 through a virtual shaft, and first swing arms 1013 of the main hinge components 101 located at two end parts in the length direction of the hinge mechanism may be rotatably connected to the base 1020 through a physical shaft.

Still refer to FIG. 6. In this application, the first rotating component 101a may further include a housing mounting bracket 1015. The housing mounting bracket 1015, the first support arm 1012a, and the swing arm 1013 are located on a same side of the base 1020, and the housing mounting bracket 1015 is connected to the first support arm 1012a and the swing arm 1013. In addition, when the hinge mechanism 1 provided in this application is used in an electronic device, the housing mounting bracket 1015 may be fastened to a housing of the electronic device.

When the housing mounting bracket 1015 is specifically disposed, refer to FIG. 9. FIG. 9 is a schematic diagram of a structure of the housing mounting bracket 1015 according to a possible embodiment of this application. In this embodiment, a first sliding groove 10151 may be disposed on the housing mounting bracket 1015, and the first sliding groove 10151 extends along a first direction. Refer to FIG. 6 and FIG. 9 together. The first support arm 1012a may be installed in the first sliding groove 10151, and may slide along the first direction in the first sliding groove 10151. The first direction may be a direction in which the housing mounting bracket 1015 moves towards or away from the base 1020. In addition, to prevent the first support arm 1012a from falling off from the first sliding groove 10151, a first sliding rail 101511 may be disposed on a slot wall of the first sliding groove 10151, and a first sliding block 10121 may be disposed on the first support arm 1012a. In this way, the first sliding block 10121 may be clamped on the first sliding rail 101511, and the first sliding block 10121 may slide along the first sliding rail 101511, to limit the first support arm 1012a in the first sliding groove 10151. In addition, the first sliding rail 101511 is disposed on the slot wall of the first sliding groove 10151, so that the first sliding rail 101511 can provide guidance for the first support arm 1012a to slide along the first sliding groove 10151. This improves motion stability of the first support arm 1012a.

Still refer to FIG. 9. The housing mounting bracket 1015 may be provided with a second sliding groove 10152. The second sliding groove 10152 may extend in a second direction, and the first sliding groove 10151 and the second sliding groove 10152 are disposed at an interval along a length direction of the housing mounting bracket 1015. Refer to FIG. 7 and FIG. 9 together. An end part, of the swing arm 1013, facing the housing mounting bracket 1015 may be installed in the second sliding groove 10152, and the swing arm 1013 may slide in the second sliding groove 10152 along the second direction. It should be noted that, in this application, the housing mounting bracket 1015 may include a first surface 1015a and a second surface 1015b that are disposed back to each other. The first surface 1015a may be a side surface, of the housing mounting bracket 1015, facing the flexible display 4 when the hinge mechanism 1 is used in the electronic device. The second direction may be a direction from the first surface 1015a to the second surface 1015b, or a direction from the second surface 1015b to the first surface 1015a. In addition, a projection along the second direction in a first cross section may not be parallel to a projection along the first direction in the first cross section. The first cross section may be a reference plane perpendicular to the rotation axis of the first support arm 1012a and the rotation axis of the swing arm 1013.

In addition, still refer to FIG. 9. In this application, a second sliding rail 101521 may be disposed in the second sliding groove 10152, and a second sliding block 10132 may be disposed on the swing arm 1013 shown in FIG. 7. In this way, the second sliding block 10132 can be clamped on the second sliding rail 101521, and the second sliding block 10132 can slide along the second direction in the second sliding rail 101521, to limit the swing arm 1013 in the second sliding groove 10152, and prevent the swing arm 1013 from falling off from the second sliding groove 10152. In addition, the second sliding rail 101521 is disposed on a slot wall of the second sliding groove 10152, so that the second sliding rail 101521 may provide guidance for the swing arm 1013 to slide along the second sliding groove 10152. This improves motion stability of the swing arm 1013.

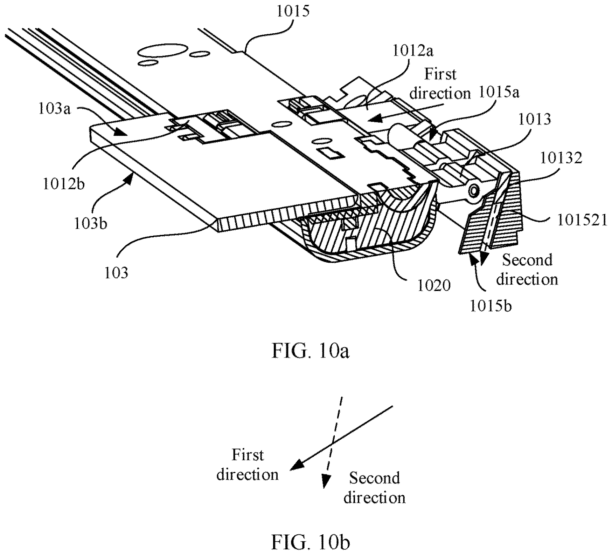

After a connection relationship between the first support arm 1012a and the swing arm 1013, the base 1020, and the housing mounting bracket 1015 provided in the foregoing embodiments of this application is understood, the following describes motions of the first support arm 1012a and the swing arm 1013 relative to the housing mounting bracket 1015. First, refer to FIG. 10a. FIG. 10a shows a relative position of the housing mounting bracket 1015 and the base 1020 when the hinge mechanism is in an unfolded state. In this case, an edge, of the housing mounting bracket 1015, facing the base 1020 is closest to the base 1020, and the second sliding block 10132 of the swing arm 1013 is closest to the first surface 1015a of the housing mounting bracket 1015.

It can be learned from the description of the foregoing embodiments that, when the hinge mechanism rotates from the unfolded state to a folded state, the first support arm 1012a may slide in the first sliding groove 10151 along the first direction, and the swing arm 1013 may slide in the second sliding groove 10152 along the second direction. In FIG. 10a, a solid line with an arrow represents the first direction, and a dashed line with an arrow represents the second direction. In addition, refer to FIG. 10b. FIG. 10b is a schematic diagram of a first cross section according to a possible embodiment. In the first cross section, a first direction and a second direction intersect, and an angle at which the first direction and the second direction intersect may be an acute angle in the figure, or may be another possible angle, for example, a right angle or an obtuse angle.

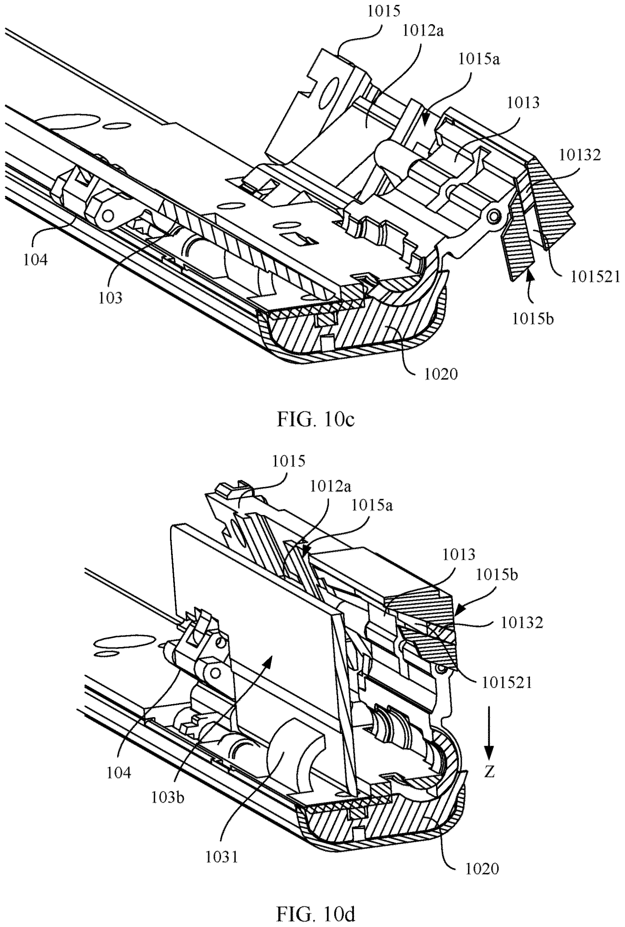

Refer to FIG. 10c. FIG. 10c shows a relative position of the housing mounting bracket 1015 and the base 1020 when the hinge mechanism is in an intermediate state. It can be seen from FIG. 10c and FIG. 10a that, in this process, the housing mounting bracket 1015 may move relative to the first support arm 1012a in a direction away from the base 1020, and drive the first support arm 1012a and the swing arm 1013 to rotate around the base 1020. The first arc-shaped rotation block 10131 of the swing arm 1013 moves towards a direction of sliding out of the first arc-shaped slot 10203, to reduce a part, of the first arc-shaped rotation block 10131, accommodated in the first arc-shaped slot 10203. The second sliding block 10132 of the swing arm 1013 slides in the second sliding rail 101521 along a direction from the first surface 1015a of the housing mounting bracket 1015 towards the second surface 1015b.

In addition, refer to FIG. 10d. FIG. 10d shows a relative position of the housing mounting bracket 1015 and the base 1020 when the electronic device is in the folded state. In a process from FIG. 10c to FIG. 10d, the housing mounting bracket 1015 continues to move relative to the first support arm 1012a in the direction away from the base 1020, and drives the first support arm 1012a to rotate around the base 1020. The first arc-shaped rotation block 10131 of the swing arm 1013 continues to move towards the direction of sliding out of the first arc-shaped slot 10203, to further reduce the part, of the first arc-shaped rotation block 10131, accommodated in the first arc-shaped slot 10203. The second sliding block 10132 of the swing arm 1013 continues to slide in the second sliding groove 10152 along the direction towards the second surface 1015b of the housing mounting bracket 1015.

It may be understood that when the electronic device rotates from the folded state shown in FIG. 10d to the unfolded state shown in FIG. 10a, the housing mounting bracket 1015, the first support arm 1012a, and the swing arm 1013 may separately move in a direction opposite to that in the foregoing rotation process from FIG. 10a to FIG. 10d. Details are not described herein again.

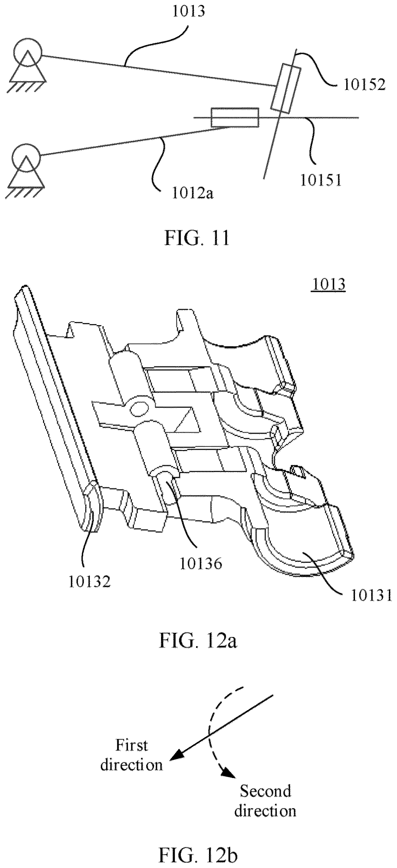

Refer to FIG. 11. FIG. 11 is a diagram of a principle of a mechanism in which the first support arm 1012a and the swing arm 1013 slide relative to the housing mounting bracket 1015 according to an embodiment of this application. It can be seen from FIG. 11 that, in the hinge mechanism 1 provided in this application, when the first support arm 1012a and the swing arm 1013 rotate around the base 1020, rotation axis centers of the first support arm 1012a and the swing arm 1013 do not overlap. This can implement a phase difference motion between the axis centers of the first support arm 1012a and the swing arm 1013. In addition, by appropriately designing disposing directions of the first sliding groove 10151 and the second sliding groove 10152, rotation angles of both the first support arm 1012a and the swing arm 1013 relative to the base 1020 can be less than or equal to 90°. Compared with the conventional solution, this solution can effectively reduce the rotation angle of the swing arm 1013, enable a wall thickness design of a local structure (for example, a structure at a position A of the swing arm 1013 shown in FIG. 7) of the swing arm 1013 to meet a strength requirement, and improve structural reliability of the swing arm 1013. In addition, this solution can effectively avoid a case in which a component in the electronic device is thinning designed, to avoid rotation of the swing arm 1013, and can improve reliability of an overall structure of the electronic device.

In addition, refer to FIG. 10d. When the hinge mechanism is in the folded state, both the first support arm 1012a and the swing arm 1013 have a support force for the housing mounting bracket 1015 in a Z direction shown in FIG. 10d, and therefore this can effectively improve a motion combination degree between the first support arm 1012a and the swing arm 1013 and the first housing mounting bracket 1015, and stop the housing mounting bracket 1015 in the direction. In this way, even if the electronic device in which the hinge mechanism is used falls in the folded state, the hinge mechanism can effectively reduce a risk of occurring a large instantaneous displacement of the housing mounting bracket 1015 relative to the hinge mechanism in this state, and ensure reliability of the overall structure of the electronic device.

In this application, the second sliding block 10132 of the swing arm 1013 may use a straight-line structure shown in FIG. 7. In this case, the second sliding rail 101521 may also be adaptively disposed as a straight-line sliding rail shown in FIG. 10a. In addition, the straight-line sliding rail has an opening located on the first surface 1015a. When the hinge mechanism is in the unfolded state shown in FIG. 10a, the straight-line sliding rail extends from the opening to a direction of the base 1020. This improves smoothness of sliding the second sliding block 10132 along the second sliding rail 101521, reduces interference of another structure on the hinge mechanism on the first swing arm 1013, helps increase the wall thickness of the first swing arm 1013, and improves structural reliability of the first swing arm 1013. In some other possible implementations of this application, the opening of the straight-line sliding rail may alternatively extend from the opening to a direction away from the base 1020; or the opening of the straight-line sliding rail may extend from the opening to a direction perpendicular to the second surface 1015b, so that the second sliding rail 101521 is disposed more flexibly. It should be noted that, in this application, the second sliding block 10132 herein may alternatively be another shape that adapts to the straight-line sliding rail, for example, may be a sliding block in an overall straight-line form with a hollow and spacing design in a middle part, or may be some special-shaped sliding blocks, as long as the sliding block can fit the sliding rail in the straight-line form for sliding.

In addition to the foregoing straight-line structure, the second sliding block 10132 of the swing arm 1013 may also be designed as a structure of another possible shape. For example, refer to FIG. 12a. FIG. 12a is a schematic diagram of a structure of the swing arm 1013 according to another possible embodiment of this application. In this embodiment, the second sliding block 10132 of the swing arm 1013 may be designed as an arc-shaped sliding block, and the arc-shaped sliding block may be, for example, a circular arc-shaped sliding block. In addition, to enable the arc-shaped sliding block of the swing arm 1013 to slide in the second sliding rail 101521 of the second sliding groove 10152 of the housing mounting bracket 1015, the second sliding rail 101521 may adaptively be designed as an arc-shaped sliding rail, and the arc-shaped sliding rail may be, for example, a circular arc-shaped sliding rail. When the hinge mechanism is in the unfolded state, an axis center of the arc-shaped sliding rail is located on a side away from the base 1020 of the arc-shaped sliding rail. This can help improve smoothness of sliding the second sliding block 10132 along the second sliding rail 101521, enable the angle at which the first swing arm 1013 rotates relative to the base 1020 to be 90°, effectively reduce interference of another structure on the hinge mechanism on motion of the first swing arm 1013, and help increase the wall thickness of the first swing arm 1013.

In this way, in this embodiment, sliding of the swing arm 1013 in the second sliding groove 10152 is sliding of the arc-shaped sliding block in the arc-shaped sliding rail. In this case, in the motion process of the hinge mechanism from the unfolded state to the folded state, or from the folded state to the unfolded state, for motion of the first support arm 1012a and the swing arm 1013 relative to the housing mounting bracket 1015, refer to FIG. 10a to FIG. 10d. Details are not described herein again.

In some other possible embodiments of this application, when the hinge mechanism is in the unfolded state, an axis center of the arc-shaped sliding rail may alternatively be located on a side, of the arc-shaped sliding rail, facing the base 1020. In this way, in the process in which the hinge mechanism rotates from the unfolded state to the folded state, the second sliding block 10132 of the first swing arm 1013 slides in the second sliding rail 101521 from the second surface 1015b of the first housing mounting bracket 1015 in a direction towards the first surface 1015a. However, in the process in which the hinge mechanism rotates from the folded state to the unfolded state, the second sliding block 10132 of the first swing arm 1013 slides in the second sliding rail 101521 from the first surface 1015a of the first housing mounting bracket 1015 in a direction towards the second surface 1015b.

It should be noted that, in this application, when the second sliding rail 101521 is an arc-shaped sliding rail, the second sliding block 10132 herein may alternatively be another shape that adapts to the arc-shaped sliding rail, for example, may be a sliding block in an overall arc-shaped form with a hollow and spacing design in a middle part, or may be some special-shaped sliding blocks, as long as the sliding block can fit the sliding rail in the arc-shaped form for sliding. In addition, when the second sliding rail 101521 is a circular arc-shaped sliding rail, the sliding of the second sliding block 10132 in the second sliding rail 101521 may alternatively be understood as rotation of the second sliding block 10132 around the first housing mounting bracket 1015.

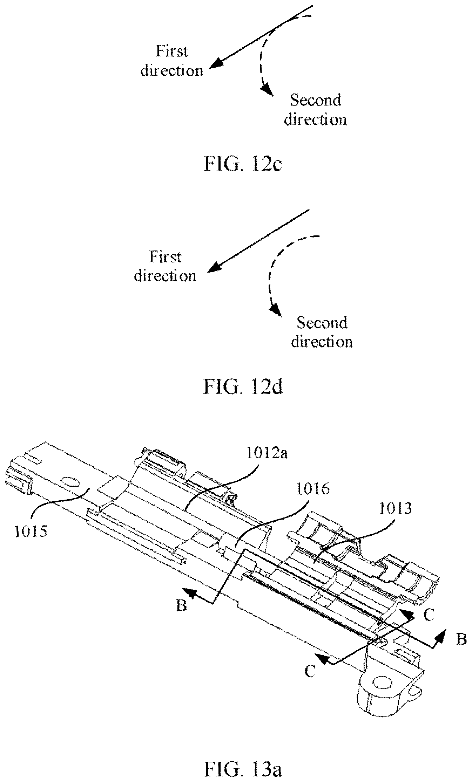

It should be noted that, when the swing arm 1013 uses a design manner shown in FIG. 12a, refer to FIG. 12b. FIG. 12b shows a schematic diagram of the first cross section according to a possible embodiment. In FIG. 12b, a solid line with an arrow represents the first direction, and a dashed line with an arrow represents the second direction. In this application, the projection along the second direction in the first cross section and the projection along the first direction in the first cross section are not parallel. In addition to intersection shown in FIG. 10b and FIG. 12b, the second direction and the first direction may further in a tangent relationship shown in FIG. 12c, or a separation relationship shown in FIG. 12d. This is not specifically limited in this application.

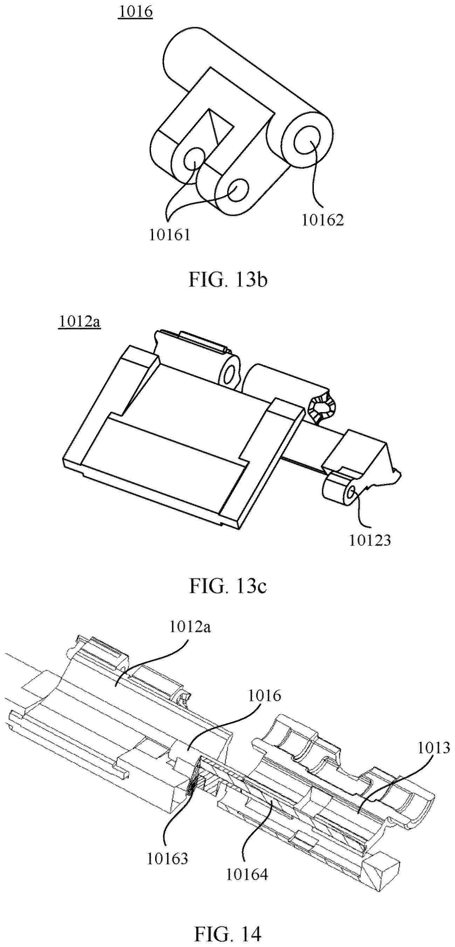

In the foregoing embodiments of this application, to improve consistency and smoothness of motion of the first support arm 1012a and the swing arm 1013, and a combination degree between the first support arm 1012a and the swing arm 1013 and corresponding sliding grooves, refer to FIG. 13a. FIG. 13a is a schematic diagram of a connection structure of the first support arm 1012a and the swing arm 1013 according to an embodiment of this application. A drive connecting rod 1016 may be disposed between the first support arm 1012a and the swing arm 1013, and the drive connecting rod 1016 may be rotatably connected to the first support arm 1012a and the swing arm 1013. During specific implementation, refer to FIG. 13b. FIG. 13b is a schematic diagram of a structure of the drive connecting rod 1016 according to a possible embodiment of this application. The drive connecting rod 1016 may include a first connection part 10161 and a second connection part 10162.

Refer to FIG. 13c. FIG. 13c is a schematic diagram of a structure of the first support arm 1012a according to a possible embodiment of this application. Refer to FIG. 13b and FIG. 13c together. In this application, the first connection part 10161 of the first drive connecting rod 1016 may be connected to a first mounting hole 10123 of the first support arm 1012a. The second connection part 10162 of the first drive connecting rod 1016 may be connected to a third mounting hole 10136 of the swing arm 1013 shown in FIG. 7 or FIG. 12a.

In addition, refer to FIG. 14. FIG. 14 is a sectional view of the structure shown in FIG. 13a at a position B-B. Refer to FIG. 13b and FIG. 14 together. The first connection part 10161 of the drive connecting rod 1016 is rotatably connected to the first support arm 1012a through a first connecting rod 10163, and the second connection part 10162 is rotatably connected to the swing arm 1013 through a second connecting rod 10164. It should be noted that axes of the first connecting rod 10163 and the second connecting rod 10164 do not overlap. This reduces a risk of interference caused to respective motion of the first support arm 1012a and the swing arm 1013.

The drive connecting rod 1016 is disposed between the first support arm 1012a and the first swing arm 1013, so that when the hinge mechanism is in the folded state, the first support arm 1012a, the first swing arm 1013, and the drive connecting rod 1016 jointly support the housing mounting bracket 1015. This stops the housing mounting bracket 1015 while effectively improving a motion combination degree between the first support arm 1012a and the swing arm 1013 and the housing mounting bracket 1015. In this way, even if the electronic device in which the hinge mechanism is used falls in the folded state, the hinge mechanism can effectively reduce a risk of occurring a large instantaneous displacement of the housing mounting bracket 1015 relative to the hinge mechanism in this state, and ensure reliability of the overall structure of the electronic device.

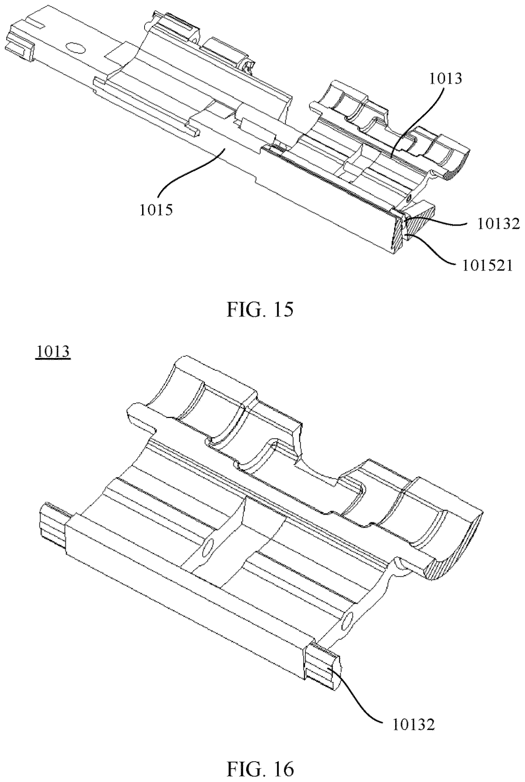

To avoid over-constraint on motion of the first support arm 1012a and the swing arm 1013 due to disposition of the drive connecting rod 1016, refer to FIG. 15. FIG. 15 is a sectional view at a position C-C in FIG. 13a. In this embodiment, the second sliding block 10132 of the swing arm 1013 may be thinning designed, so that the second sliding block 10132 of the swing arm 1013 can be in clearance fit with the second sliding rail 101521 of the housing mounting bracket 1015. During specific implementation, refer to FIG. 16. FIG. 16 is a schematic diagram of a structure of the swing arm 1013 according to another possible embodiment of this application. In this embodiment, a thickness of the second sliding block 10132 of the swing arm 1013 is reduced, so that a gap exists between the second sliding block 10132 and a side wall of the second sliding rail 101521. In this case, a shape of the second sliding block 10132 may match a shape of the second sliding rail 101521. For example, when the second sliding rail 101521 is a rectangular sliding rail, the second sliding block 10132 may be set as a rectangular sliding block. Alternatively, the second sliding block 10132 may be set as a pin shaft, so that the second sliding block 10132 can rotate relative to the second sliding rail 101521 while sliding in the second sliding rail 101521. Therefore, in a process in which the second sliding block 10132 slides along the second sliding rail 101521 shown in FIG. 15, the hinge mechanism can increase freedom of motion of the swing arm 1013, and ensure reliability of cooperation between the swing arm 1013 and the second sliding groove 10152 of the housing mounting bracket 1015.

It should be noted that, in the foregoing embodiments, the drive connecting rod 1016 is rotatably connected to the support arm 1012a through the first connecting rod 10163, and is rotatably connected to the swing arm 1013 through the second connecting rod 10164. This can enable the first support arm 1012a, the first connecting rod 10163, the swing arm 1013, and the second connecting rod 10164 to form a four-connecting rod mechanism. It may be understood that, rod lengths between structures on the four-connecting rod mechanism are adjusted, so that the formed four-connecting rod structure can be in a parallel quadrilateral or a non-parallel quadrilateral.

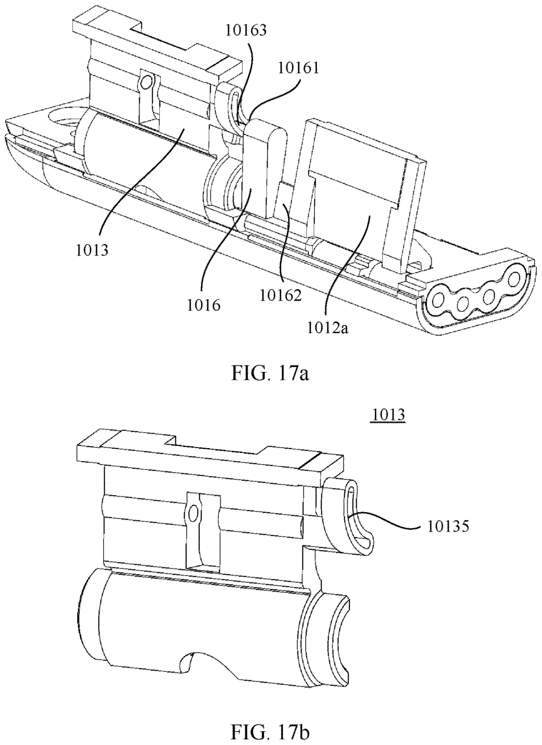

In addition, in addition to the disposing manner provided in the foregoing embodiment, for the drive connecting rod 1016, refer to FIG. 17a. FIG. 17a is a schematic diagram of a connection structure of the first support arm 1012a and the swing arm 1013 according to another embodiment of this application. In this embodiment, the drive connecting rod 1016 is also located between the first support arm 1012a and the swing arm 1013. Different from those in the foregoing embodiment, in this embodiment, the first connection part 10161 of the drive connecting rod 1016 is slidably connected to the swing arm 1013 through the first connecting rod 10163, and the second connection part 10162 is fastened to the first support arm 1012a.

Refer to FIG. 17b. FIG. 17b is a schematic diagram of a structure of the swing arm 1013 according to another possible embodiment of this application. Refer to FIG. 17a and FIG. 17b together. A guiding slot 10135 may be disposed at an end part, of the swing arm 1013, facing the first support arm 1012a, and the first connecting rod 10163 can be inserted into the guiding slot 10135 and can slide along a slot surface of the guiding slot 10135, so that the first connecting rod 10163 is slidably connected to the swing arm 1013.

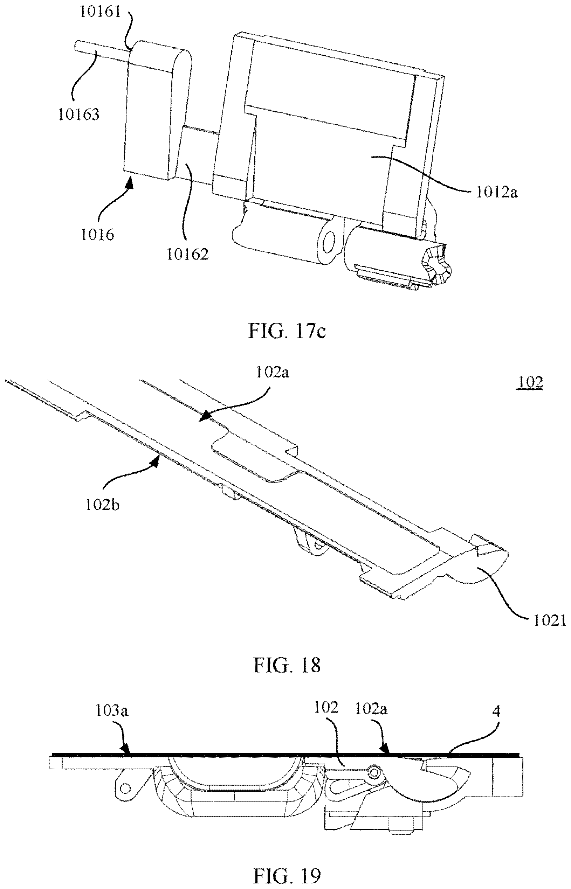

In addition, refer to FIG. 17c. FIG. 17c is a schematic diagram of a connection structure of the drive connecting rod 1016 and the first support arm 1012a. In this application, the second connection part 10162 of the drive connecting rod 1016 may be fastened to the first support arm 1012a in a manner of bonding, threaded connection, or the like. In some other possible embodiments of this application, the drive connecting rod 1016 and the first support arm 1012a may be an integrated structure.

It may be understood that, in some possible embodiments of this application, the drive connecting rod 1016 may alternatively be slidably connected to the first support arm 1012a, and fastened to the swing arm 1013. A specific set manner is similar to that in the embodiment in which the drive connecting rod 1016 is slidably connected to the swing arm 1013 and fastened to the first support arm 1012a. Details are not described herein again.

In the disposing manner, the guiding slot 10135 can be appropriately designed for the drive connecting rod 1016, to improve a combination degree between the first support arm 1012a and the swing arm 1013 and the corresponding sliding grooves, improve motion consistency between the first support arm 1012a and the swing arm 1013, and enable motion of the first support arm 1012a and the swing arm 1013 to be smoother. In addition, when the electronic device in which the hinge mechanism is used falls in the folded state, the first support arm 1012a, the swing arm 1013, and the drive connecting rod 1016 can jointly support a housing of the electronic device. This can avoid causing a large instantaneous displacement of the housing relative to the hinge mechanism, and improve reliability of the overall structure of the electronic device.

In addition, in this embodiment, to avoid over-constraint on motion of the first support arm 1012a and the swing arm 1013 due to disposition of the drive connecting rod 1016, the second sliding block 10132 of the swing arm 1013 can be thinning designed, so that the second sliding block 10132 of the swing arm 1013 is in clearance fit with the second sliding rail 101521 of the first housing mounting bracket 1015. For a specific disposing manner, refer to the foregoing embodiments. Details are not described herein again.

In this application, to form the accommodating space between the first support plate 102, the second support plate 103, and the base 1020, the first support plate 102 may be rotatably connected to the housing mounting bracket 1015. It should be noted that the first support plate 102 may be rotatably connected to multiple housing mounting brackets 1015 located on a same side of the base 1020. This helps simplify the structure of the hinge mechanism 1, and can improve structural reliability of the hinge mechanism 1. In addition, when the hinge mechanism 1 provided in this application is used in the electronic device, the second support plate 103 may be fastened to one housing of the electronic device, or the second support plate 103 is a part of one housing of the electronic device.

Specifically, when the first support plate 102 is rotatably connected to the housing mounting bracket 1015, refer to the housing mounting bracket 1015 shown in FIG. 9. The housing mounting bracket 1015 may be provided with a rotating slot 10153, and the rotating slot 10153 may be a circular arc-shaped slot. In addition, refer to FIG. 18. FIG. 18 is a schematic diagram of a structure of the first support plate 102 according to a possible embodiment of this application. A rotating part 1021 may be disposed at an end part, of the first support plate 102, facing the housing mounting bracket 1015, and the rotating part 1021 may be disposed in an arc shape, for example, in a circular arc shape. In this way, the rotating part 1021 may be installed in the rotating slot 10153, and the rotating part 1021 may slide along a slot surface of the rotating slot 10153, to implement relative rotation between the first support plate 102 and the housing mounting bracket 1015.

In addition, refer to FIG. 19. FIG. 19 is a schematic diagram of a structure of supporting the flexible display 4 by the first support plate 102 and the second support plate 103 according to a possible embodiment of this application. In FIG. 19, the electronic device is in the unfolded state. In this case, the first plate surface 102a of the first support plate 102 and the second plate surface 103a of the second support plate 103 may be in a same plane as a surface, of the cover (not shown in FIG. 19), facing the flexible display 4, so that the flexible display 4 can be smoothly supported.

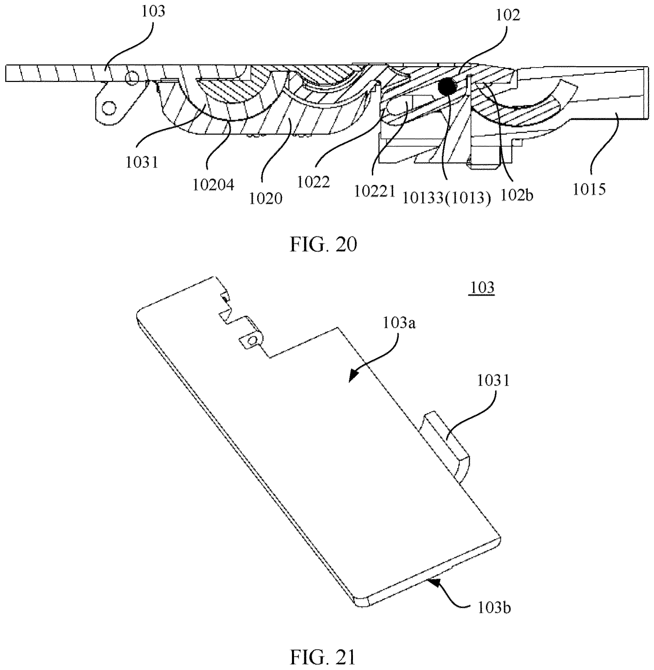

Refer to FIG. 20. FIG. 20 is a sectional view of the hinge mechanism 1 according to a possible embodiment of this application. FIG. 20 may show a structure of a second surface of the first support plate 102 and a connection relationship between the first support plate 102 and another structure on the hinge mechanism 1. In this application, the second surface of the first support plate 102 may be denoted as a third plate surface 102b. A first guiding part 1022 may be disposed on the third plate surface 102b of the first support plate 102, and a first track slot 10221 may be disposed on the first guiding part 1022. In addition, in this application, the swing arm 1013 may be provided with a first guiding structure 10133. The first guiding structure 10133 may be but is not limited to a columnar structure, and the first guiding structure 10133 may be inserted into the first track slot 10221 of the first guiding part 1022 of the first support plate 102, and may slide along the first track slot 10221. In this way, in the process in which the swing arm 1013 rotates around the base 1020, the first guiding structure 10133 may slide in the first track slot 10221, to drive the first support plate 102 to rotate around the housing mounting bracket 1015.

In another possible embodiment of this application, the first support arm 1012a may further drive the first support plate 102 to rotate around the housing mounting bracket 1015. During specific implementation, a first guiding part 1022 may be disposed on the third plate surface 102b of the first support plate 102, and a first track slot 10221 may be disposed on the first guiding part 1022. In addition, a first guiding structure 10133 may be disposed on the first support arm 1012a. The first guiding structure 10133 may be but is not limited to a columnar structure, and the first guiding structure 10133 may be inserted into the first track slot 10221 of the first guiding part 1022 of the first support plate 102, and may slide along the first track slot 10221. In this way, in the process in which the first support arm 1012a rotates around the base 1020, the first guiding structure 10133 may slide in the first track slot 10221, to drive the first support plate 102 to rotate around the housing mounting bracket 1015. In some possible embodiments of this application, the first support plate 102 may alternatively be slidably connected to both the first support arm 1012a and the swing arm 1013. For a slidable connection manner, refer to the foregoing embodiments. Details are not described herein again. This drives the first support plate 102 to rotate around the housing mounting bracket 1015 by rotating the first support arm 1012a and the swing arm 1013 around the base 1020.

Refer to FIG. 21. FIG. 21 is a schematic diagram of a structure of the second support plate 103 according to a possible embodiment of this application. In this application, the second support plate 103 and the base 1020 are in a single-axis rotation connection manner, and rotation axis centers of the second support plate 103 and the first support plate 102 do not overlap. During specific implementation, a second arc-shaped rotation block 1031 may be disposed at an end, of the second support plate 103, rotatably connected to the base 1020. Refer to FIG. 19 and FIG. 20 together. A second arc-shaped slot 10204 may be disposed on the base 1020, and the second arc-shaped rotation block 1031 may slide along a slot surface of the second arc-shaped slot 10204, so that the second support plate 103 can be rotatably connected to the base 1020 through a virtual shaft. This helps reduce space occupied by the second support plate 103 on the base 1020, and implements a miniaturization design of the hinge mechanism. In another possible embodiment of this application, the second support plate 103 may alternatively be rotatably connected to the base 1020 through a physical rotating shaft, to improve reliability of the connection between the second support plate 103 and the base 1020.

In this way, in a possible embodiment of this application, when the hinge mechanism includes multiple main hinge components 101, second support plates 103 of the main hinge components 101 disposed opposite to the flexible display of the electronic device may be rotatably connected to the base 1020 through a virtual shaft, and second support plates 103 of the main hinge components 101 located at two end parts in the length direction of the hinge mechanism may be rotatably connected to the base 1020 through a physical shaft.

In addition, refer to FIG. 6. In this application, the second rotating component may further include a second support arm 1012b, and the second support arm 1012b may be rotatably connected to the base 1020 via a second pin shaft 10201b. The second pin shaft 10201b may be disposed on both the damping support 10202 and the second support arm 1012b, so that the second support arm 1012b is rotatably connected to the damping support 10202 via the second pin shaft 10201b, and the second rotating component is rotatably connected to the base 1020.

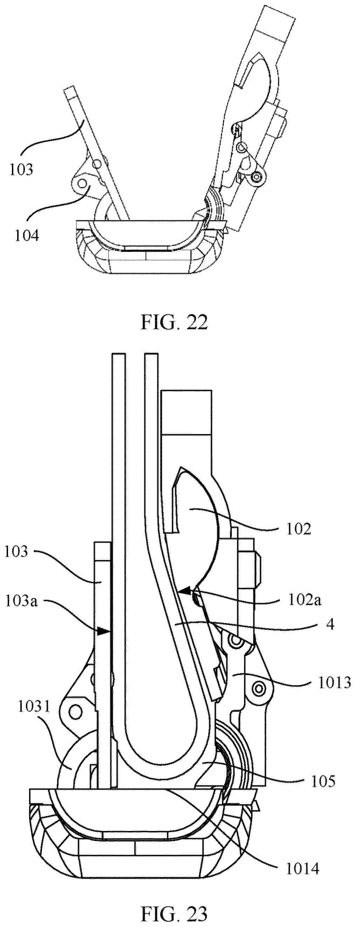

In addition, in this application, the second support arm 1012b may be rotatably connected to the second support plate 103. During specific implementation, refer to FIG. 22. FIG. 22 is a schematic diagram of a structure of the hinge mechanism according to a possible embodiment of this application. In this embodiment, an end part, of the second support arm 1012b (not shown in FIG. 22 and may refer to FIG. 6), facing the second support plate 103 may be rotatably connected to the second support plate 103 through a connecting rod component 104. It may be understood that, the connecting rod component 104 may include at least two connecting rod pieces hinged with each other, for example, may include two connecting rod pieces hinged with each other to form a two-connecting rod component, or may include three connecting rod pieces hinged with each other to form a three-connecting rod component. In addition, the connecting rod component 104 is appropriately designed, to adjust a rotation track of the second support plate 103 relative to the base 1020.

The second support arm 1012b may be rotatably connected to the second support plate 103 through the connecting rod component 104. In addition, in some possible embodiments of this application, a second guiding part may be disposed on the second support plate 103. For example, the second guiding part may be disposed on a second surface of the second support plate 103. Refer to FIG. 21, in this application, the second surface of the second support plate 103 may be denoted as a fourth plate surface 103b. In addition, a second track slot may be disposed in the second guiding part. In addition, a second guiding structure may be disposed at an end plate, of the second support arm 1012b, facing the second support plate 103. The second guiding structure may be but not limited to a columnar structure, and the second guiding structure may be inserted into a second track slot of the second guiding part of the second support plate 103, and may slide along the second track slot. In this way, in a process in which the second support arm 1012b rotates around the base 1020, the second support arm 1012b may be rotatably connected to the second support plate 103 by sliding the second guiding structure in the second track slot. In addition, in this embodiment, the second track slot can be appropriately designed, to adjust a rotation track of the second support plate 103 relative to the base 1020.

In this application, when the first support arm 1012a and the second support arm 1012b rotate towards each other, the first support arm 1012a or the swing arm 1013 may drive an end, of the first support plate 102, close to the base 1020 to move in the direction away from the base 1020. In this way, refer to FIG. 23. FIG. 23 shows that when the hinge mechanism is in the folded state, the first support plate 102, the second support plate 103, and the cover plate 1014 may form the display accommodating space 105. It may be understood from the foregoing description of the structure of the hinge mechanism 1 that, in the process in which the electronic device changes from the unfolded state to the folded state, the first support plate 102 may rotate around the housing mounting bracket 1015 under the driving of the swing arm 1013 and/or the first support arm 1012a, so that the end part, of the first support plate 102, close to the base 1020, moves in the direction away from the base 1020. The second support plate 103 is always connected to the base 1020 via the second arc-shaped rotation block 1031, so that the first rotating component and the second rotating component of the hinge mechanism are asymmetrically disposed relative to each other or relative to the base. Such a design can effectively reduce the width of the hinge mechanism, enable the structure of the hinge mechanism to be simple, and reduce the weight of the hinge mechanism. In addition, the display accommodating space 105 formed between the first support plate 102, the second support plate 103, and the cover plate 1014 may be a triangular interval that is shown in FIG. 23 and that tilts towards the side of the first support plate 102, so that the bent part, of the flexible display 4, accommodated in the display accommodating space 105 presents the asymmetrical water-drop-like form shown in FIG. 22. This can prevent the flexible display 4 from being squeezed, effectively reduce a crease width of the flexible display 4 while reducing a risk of damage to the flexible display 4, and help improve user experience.

In this application, the first sliding groove 10151 and the second sliding groove 10152 are disposed on the housing mounting bracket 1015, so that in the process in which the housing mounting bracket 1015 rotates around the base 1020, the first support arm 1012a slides in the first sliding groove 10151 along the first direction, and the swing arm 1013 slides in the second sliding groove 10152 along the second direction, where the projection along the first direction in the first cross section may intersect with the projection along the second direction in the first cross section, and the first cross section may be the reference plane perpendicular to the rotation axis of the first support arm 1012a and the rotation axis of the swing arm 1013. When the first support arm 1012a and the swing arm 1013 rotate around the base 1020, the rotation axis centers of the first support arm 1012a and the swing arm 1013 do not overlap. This can implement a phase difference motion between the axis centers of the first support arm 1012a and the swing arm 1013. In addition, by appropriately designing disposing directions of the first sliding groove 10151 and the second sliding groove 10152, rotation angles of both the first support arm 1012a and the swing arm 1013 relative to the base 1020 can be 90°. It may be understood that, in the hinge mechanism 1 provided in this application, the rotation angle of the swing arm 1013 may be adjusted by adjusting the first track slot of the first support plate 102. For example, a maximum rotation angle of the swing arm 1013 may be less than or equal to 90°. Refer to FIG. 23 and FIG. 7 together. When the electronic device is in the folded state, a distance between the first arc-shaped rotation block 10131 of the swing arm 1013 and the flexible display 4 is long. This can prevent the swing arm 1013 from squeezing or pulling the flexible display 4, reduce the risk of damage to the flexible display 4, and prolong the service life of the flexible display 4.

In addition, the second support plate 103 is always connected to the base 1020 via the second arc-shaped rotation block 1031, so that when the electronic device is in the folded state, the display accommodating space 105 formed by the hinge mechanism 1 can be the tilted triangular interval. This can enable the bent part, of the flexible display 4, accommodated in the display accommodating space 105 to be in the asymmetrical water-drop-like form, helps reduce the width of the bent area of the flexible display 4, improve light and shadow of the flexible display 4, and helps improve user experience.

It should be noted that, still refer to FIG. 23. In this application, the flexible display 4 of the electronic device may be fastened to the first support plate 102 and the second support plate 103, and a connection manner may be but is not limited to bonding. During specific implementation, the flexible display 4 may be bonded to a partial area of the first plate surface 102a of the first support plate 102, for example, may be bonded to a partial area, of the first plate surface 102a, close to the base 1020; and the flexible display 4 may be bonded to a partial area of the second plate surface 103a of the second support plate 103, for example, may be bonded to a partial area, of the second plate surface 103a, close to a housing at a corresponding side. Therefore, when the electronic device is in the unfolded state, the two housings, the first support plate 102, and the second support plate 103 can jointly smoothly support the flexible display 4. In the process in which the electronic device changes from the unfolded state to the folded state, the two support plates can drive the flexible display to rotate. This can effectively avoid deformation of the flexible display 4, and reduce the risk of damage to the flexible display. In addition, when the electronic device is in the folded state shown in FIG. 23, the flexible display 4 can be fit with the two support plates. This can help improve light and shadow of the flexible display.

In addition to the foregoing structures, in some embodiments of this application, the hinge mechanism 1 may be provided with another possible structure. For example, still refer to FIG. 6. In this embodiment, the main hinge module 101 may further include a synchronization component 1017. The synchronization component 1017 may include a first drive gear 10171a disposed at an end part of the first support arm 1012a and a second drive gear 10171b disposed at an end part of the second support arm 1012b, and the first drive gear 10171a and the second drive gear 10171b are engaged. In this way, in a process in which one support arm rotates around the base 1020, the other support arm may be driven to rotate synchronously around the base 1020 in a direction towards or away from each other, and the two support arms rotate at a same angle.

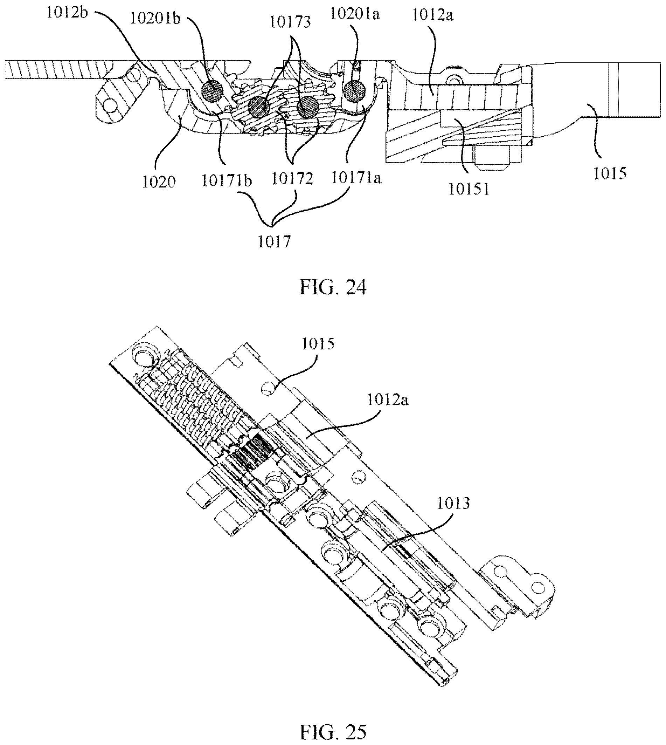

Refer to FIG. 24. FIG. 24 is a sectional view at a position D-D of the main hinge module 101 shown in FIG. 6. In this application, the synchronization component 1017 may further include a driven gear 10172, and the driven gear 10172 may be disposed between the first drive gear 10171a and the second drive gear 10171b. In addition, there may be an even number of driven gears 10172, and adjacent driven gears 10172 and a driven gear 10172 and a drive gear that are adjacent to each other are engaged, so that the first drive gears 10171a and the second drive gears 10171b can rotate synchronously via the even number of driven gears 10172.

To improve motion stability of the synchronization component 1017, in this application, the first drive gear 10171a may be sleeved on the first pin shaft 10201a, and the second drive gear 10171b may be sleeved on the second pin shaft 10201b. In addition, the synchronization component 1017 may further include a middle shaft 10173, where the middle shaft 10173 may be located between the first pin shaft 10201a and the second pin shaft 10201b, and each driven gear 10172 is sleeved on one middle shaft 10173.

It should be noted that, in this application, the synchronization component 1017 may be disposed on the base 1020, and may be accommodated in the accommodating space formed between the cover plate 1014 and the base 1020, so that the structure of the hinge mechanism 1 is compact. In the hinge mechanism 1 provided in this application, the synchronization component 1017 is disposed, so that in the process in which one support arm rotates around the base 1020, the other support arm can be driven to rotate synchronously around the base 1020 in the direction towards or away from each other. In addition, because the first support arm 1012a may slide along the first sliding groove 10151 of the housing mounting bracket 1015, in the process in which the first support arm 1012a rotates around the base 1020, the housing mounting bracket 1015 may be driven to rotate at the same angle. In addition, because the housing mounting bracket 1015 may be fastened to a housing of the electronic device, the housing of the electronic device may rotate at the same angle as the first support arm 1012a. In addition, in this application, the second support plate 103 may be fastened to the other housing of the electronic device. In this case, in the process in which the second support arm 1012b rotates around the base 1020, the second support plate 103 may be driven to rotate at the same angle, so that the other housing of the electronic device can rotate at the same angle as the second support plate 103. In this way, synchronous rotation of the first support arm 1012a and the second support arm 1012b can implement synchronous rotation of the two housings of the electronic device. This can prevent an instantaneous acting force from being applied to the flexible display fastened to the two housings, and help improve reliability of the flexible display.

Still refer to FIG. 6. In this application, a damping component 1018 may be disposed in the main hinge module 101. The damping component 1018 may include an elastic member 10181 and a conjoined cam 10182. In a length direction of the main hinge module 101, the conjoined cam 10182 is located between the elastic member 10181 and the first support arm 1012a and the second support arm 1012b, and the conjoined cam 10182 presses against the first support arm 1012a and the second support arm 1012b under the action of an elastic force of the elastic member 10181.

In addition, a first cam surface may be disposed at an end part, of the first support arm 1012a, facing the conjoined cam 10182, and a second cam surface may be disposed on at end part, of the second support arm 1012b, facing the conjoined cam 10182. When the first drive gear 10171a is disposed on the first support arm 1012a, a first gear surface may be disposed at an end part of the first drive gear 10171a. Similarly, when the second drive gear 10171b is disposed on the second support arm 1012b, a second gear surface may be disposed at an end part of the second drive gear 10171b. A third cam surface may be disposed at an end part, of the conjoined cam 10182, facing the first support arm 1012a, and a fourth cam surface may be disposed at an end part, of the conjoined cam 10182, facing the second support arm 1012b. In this case, under the action of the elastic force of the elastic member 10181, the corresponding first cam surface presses against the corresponding third cam surface, and the corresponding second cam surface presses against the corresponding fourth cam surface.

It should be noted that, in this application, a cam surface includes multiple protrusion parts and recessed parts. When slopes of protrusion parts of two cam surfaces are in contact with each other, a damping force that prevents the two cam surfaces from continuing to rotate relative to each other may be generated between the two cam surfaces. Based on this, in the process in which the two support arms rotate around the base 1020, the damping component 1018 may provide a specific damping force for the two support arms. The damping force may be transferred to the housing mounting bracket 1015 on corresponding sides via the support arms, so that the housing mounting bracket 1015 acts on the housing of the electronic device. In this application, the damping component 1018 is disposed in the main hinge module 101. This can avoid false unfolding and folding of the electronic device, and can implement suspension of the two housings at a specified position. In addition, a user may have an obvious feeling in a process of unfolding or folding the electronic device. This helps improve user experience.

When being specifically disposed, the elastic member 10181 may include multiple springs disposed side by side. In addition, some springs in the elastic member 10181 may be sleeved on the first pin shaft 10201a and the second pin shaft 10201b, and the other springs may be sleeved on the middle shaft 10173. This helps improve motion stability of the elastic member 10181.

Still refer to FIG. 6. The damping component 1018 may further include a stopper 10183, and the elastic member 10181 is located between the stopper 10183 and the conjoined cam 10182. The stopper 10183 may also be sleeved on the first pin shaft 10201a, the second pin shaft 10201b, and the middle shaft 10173. The stopper 10183 may be disposed to squeeze the elastic member 10181, so that the elastic member 10181 accumulates elastic forces. In addition, the damping component 1018 may further include a circlip 10184. The stopper 10183 is located between the elastic member 10181 and the circlip 10184, and the circlip 10184 may be clamped on the first pin shaft 10201a, the second pin shaft 10201b, and the middle shaft 10173, so as to limit the elastic member 10181 and the conjoined cam 10182. This can prevent the elastic member 10181 from falling off from the first pin shaft 10201a, the second pin shaft 10201b, and the middle shaft 10173.

In the hinge mechanism 1 provided in this application, in addition to the slidable connection provided in the foregoing embodiments between the swing arm 1013 of the first rotating component and the housing mounting bracket 1015, in some possible embodiments, the swing arm 1013 may be connected to the housing mounting bracket 1015 in another possible manner.

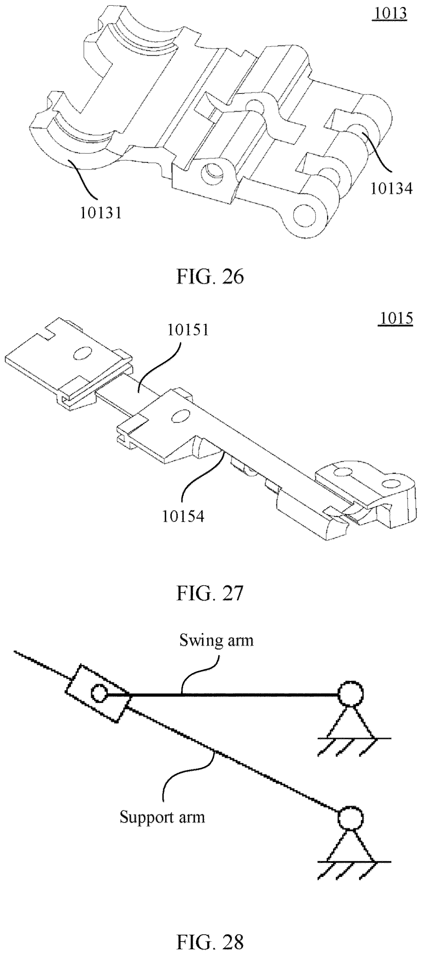

For example, refer to FIG. 25. FIG. 25 is a schematic diagram of a structure of the hinge mechanism according to another possible embodiment of this application. In this embodiment, the swing arm 1013 may be rotatably connected to the housing mounting bracket 1015. During specific implementation, refer to FIG. 26. FIG. 26 is a schematic diagram of a structure of the swing arm 1013 according to another possible embodiment of this application. A second mounting hole 10134 is disposed at an end, of the swing arm 1013, mounted to the housing mounting bracket 1015.

In addition, refer to FIG. 27. FIG. 27 is a schematic diagram of a structure of the housing mounting bracket 1015 according to another possible embodiment of this application. The housing mounting bracket 1015 has a mounting part 10154, and in the length direction of the housing mounting bracket 1015, the mounting part 10154 and the first sliding groove 10151 are disposed at an interval. In this case, the second mounting hole 10134 may be rotatably connected to the mounting part 10154 via a rotating shaft. In another possible embodiment of this application, a second mounting hole 10134 may be disposed on the housing mounting bracket 1015, and a mounting part 10154 is disposed on the swing arm 1013. In this case, the second mounting hole 10134 may also be rotatably connected to the mounting part 10154 via a rotating shaft.

It should be noted that, in embodiments of this application, for a manner of connecting the swing arm 1013 to the base 1020 and a manner of connecting the first support arm 1012a to the housing mounting bracket 1015, refer to any one of the foregoing embodiments. For example, the swing arm 1013 may be rotatably connected to the first arc-shaped slot 10203 of the base 1020 via the first arc-shaped sliding block, and the first support arm 1012a may slide along the first sliding groove 10151 of the housing mounting bracket 1015. Details are not described herein.

In embodiments of this application, the first support arm 1012a is slidably connected to the housing mounting bracket 1015, and the swing arm 1013 is rotatably connected to the housing mounting bracket 1015 through the solid axis. Therefore, refer to FIG. 28. FIG. 28 is a diagram of a principle of a motion mechanism of the first support arm 1012a and the swing arm 1013 in this embodiment. It can be seen from FIG. 28 that, in the hinge mechanism 1 provided in embodiments of this application, the first support arm 1012a and the swing arm 1013 may form a connecting rod-sliding block mechanism. In the process in which the hinge mechanism 1 changes from the unfolded state to the folded state as the electronic device, the rotation angle of the first support arm 1012a may be 90°, but a rotation angle of the swing arm 1013 needs to be greater than 90°. However, in the rotation process of the hinge mechanism 1, to enable the swing arm 1013 to avoid the flexible display 4, avoidance processing needs to be performed on a part that interferes with rotation of the swing arm 1013, so that when the electronic device is in the unfolded state, the hinge mechanism 1 can smoothly support the flexible display 4; and when the electronic device is in the folded state, the hinge mechanism 1 can provide the sufficient display accommodating space 105 for the flexible display 4.

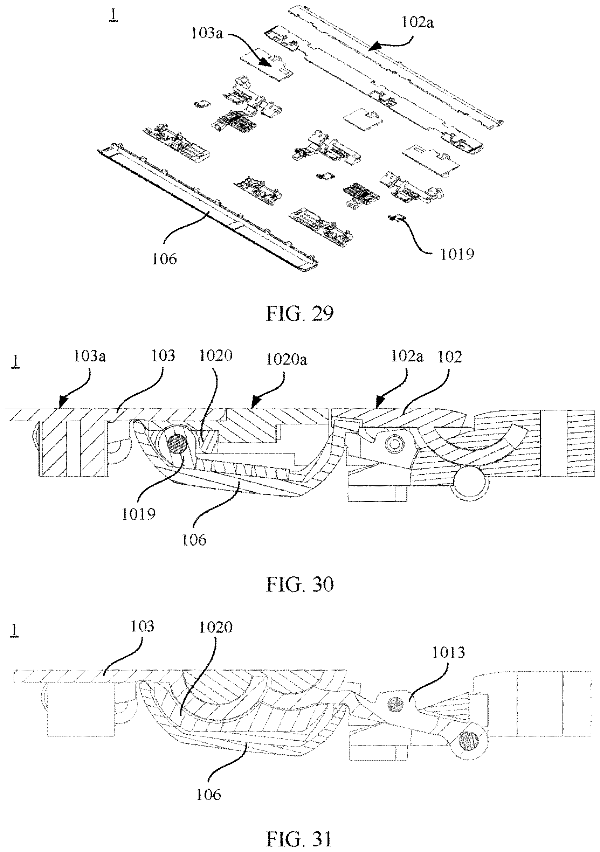

During specific implementation, refer to FIG. 29. FIG. 29 is an exploded view of a hinge mechanism 1 according to another possible embodiment of this application. In this embodiment, the hinge mechanism 1 may be provided with an end cover 106 and a rotation member 1019. The end cover 106 may be used as an appearance member of the hinge mechanism 1, and may protect another structure on the hinge mechanism 1, and help improve appearance aesthetics of the hinge mechanism 1.

In addition, refer to FIG. 30. FIG. 30 is a sectional view at a position, of the hinge mechanism 1, at which the rotation member 1019 is disposed according to an embodiment of this application. In this embodiment of this application, the end cover 106 has an accommodation part, and the base 1020 of the main hinge module 101 may be disposed in the accommodation part of the end cover 106. In addition, one end of the rotation member 1019 presses against a bottom surface, of the end cover 106, facing the base 1020, and the other end of the rotation member is rotatably connected to the base 1020. In a process in which the first support arm 1012a and the second support arm 1012b rotate away from each other, the swing arm 1013 rotates around the base 1020 to drive the end cover 106 to rotate around the base 1020, and a rotation direction of the end cover 106 is the same as a rotation direction of the swing arm 1013. This avoids the swing arm 1013. It may be understood that, in embodiments of this application, a rotation member 1019 may be disposed in at least one main hinge module 101, to simplify the structure of the hinge mechanism. Alternatively, a rotation member 1019 may be disposed for each main hinge module 101, to improve motion stability of the end cover 106.

It should be noted that, in embodiments of this application, for specific disposition manners of the first support plate 102 and the second support plate 103, refer to the foregoing embodiments. Details are not described herein again.

Still refer to FIG. 30. FIG. 30 shows the structure of the hinge mechanism 1 in the unfolded state. In this case, the first plate surface 102a of the first support plate 102, the second plate surface 103a of the second support plate 103, and the bearing surface 1020a of the base 1020 are located in a same plane, to smoothly support the flexible display.

Refer to FIG. 31. FIG. 31 is a sectional view at the swing arm 1013 when the hinge mechanism 1 is in the unfolded state. In this case, in avoidance of the end cover 106, an angle at which the swing arm 1013 rotates relative to the base 1020 is greater than 90°.

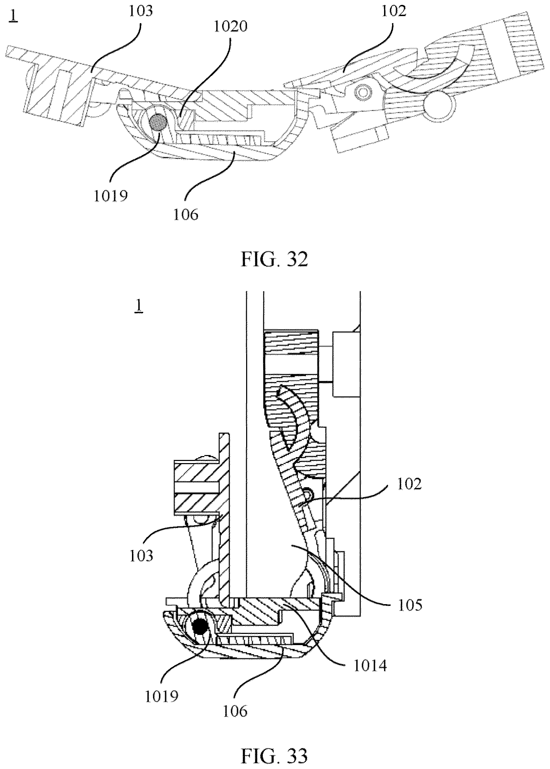

In addition, in this application, the hinge mechanism 1 may further include a resetting element. The resetting element may be but is not limited to a return spring, a magnetic element, or the like. In this case, the rotation member 1019 may be rotatably connected to the base 1020 via the resetting element. Refer to FIG. 32. FIG. 32 shows the structure of the hinge mechanism 1 in the intermediate state. It can be seen by comparing FIG. 30 and FIG. 32 that, in the process in which the hinge mechanism 1 rotates from the unfolded state shown in FIG. 30 to the folded state, the first support plate 102 and the second support plate 103 move oppositely, and the swing arm 1013 rotates around the base 1020 in a direction towards the second support plate 103. In this process, the rotation member 1019 may rotate around the base 1020 under the action of the resetting element, and a rotation direction of the rotation member 1019 is the same as a rotation direction of the swing arm 1013, to drive the end cover 106 and the swing arm 1013 to rotate in a same direction.

Refer to FIG. 33. FIG. 33 shows the structure of the hinge mechanism 1 in the folded state. In this state, the triangular display accommodating space 105 that tilts toward the side of the first support plate 102 may be formed between the first support plate 102, the second support plate 103, and the cover plate 1014, so that the bent part, of the flexible display 4, that can be accommodated in the display accommodating space 105 is in the asymmetrical water-drop-like form. This can prevent the flexible display 4 from being squeezed, effectively reduce the width of the bent area of the flexible display 4 while reducing the risk of damage to the flexible display 4, and help improve user experience.

It may be understood that, in the process in which the hinge mechanism 1 rotates from the folded state shown in FIG. 33 to the unfolded state shown in FIG. 30, as the swing arm 1013 rotates around the base 1020, the end cover 106 may be driven to rotate around the base 1020 in a same direction, so that the end cover 106 avoids the swing arm 1013, and when the hinge mechanism is in the unfolded state, the hinge mechanism 1 can smoothly support a corresponding part of the flexible display 4.

In embodiments of this application, rotation of the swing arm 1013 is effectively avoided by rotating the end cover 106. This can effectively avoid thinning designs of the swing arm 1013 and another structure on the electronic device, and improve reliability of the overall structure of the electronic device.

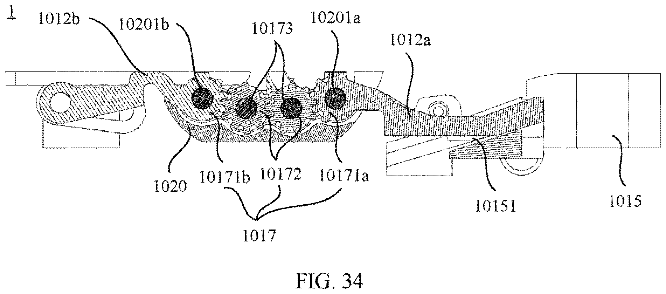

In addition, in embodiments of this application, the synchronization component 1017 and the damping component 1018 may be disposed in the main hinge module 101. For a specific manner of disposing the synchronization component 1017 and the damping component 1018, refer to any one of the foregoing embodiments. Details are not described herein again. In this way, refer to FIG. 34. FIG. 34 is a sectional view of a part, of the hinge mechanism 1, provided with the synchronization component 1017 according to this embodiment. In this embodiment, the first support arm 1012a and the second support arm 1012b may synchronously rotate around the base 1020 at a same rotation angle via the synchronization component 1017, so that the two housings of the electronic device in which the hinge mechanism 1 is used synchronously rotate around the base 1020 at a same rotation angle. This can prevent an instantaneous acting force from being applied to the flexible display 4 fastened to the two housings, and help improve reliability of the flexible display 4.

The damping module is disposed to avoid false unfolding and folding of the electronic device, and can implement suspension of the two housings at the specified position. In addition, the user may have an obvious feeling in the process of unfolding or folding the electronic device. This helps improve user experience.

The hinge mechanism 1 provided in the foregoing embodiments of this application may be used in, for example, the electronic device shown in FIG. 2. The housing mounting bracket 1015 may be fastened to a housing located on a same side of the base 1020, and the second support plate 103 may be fastened to the other housing. For example, the housing mounting bracket 1015 may be fastened to the first housing 2 of the electronic device shown in FIG. 4, and the second support plate 103 may be fastened to the second housing 3 of the electronic device shown in FIG. 3. It should be noted that the second support plate 103 may be a part of a middle frame of the second housing 3, that is, the second support plate 103 and the middle frame of the second housing 3 are integrated. Alternatively, the second support plate 103 may be independent, and may be fastened to the second housing 3 in a possible manner such as bonding or threaded connection.

In this application, when the electronic device is in the unfolded state, the bearing surface 1020a of the base 1020, the first support surface 2b of the first housing 2, the second support surface 3b of the second housing 3, the first plate surface 102a of the first support plate 102, and the second plate surface 103a of the second support plate 103 may jointly smoothly support the flexible display 4. This can ensure that the form of the electronic device in the unfolded state is complete.

It should be noted that, in this application, when the electronic device is in the folded state, the second plate surface 103a and the second support surface 3b are located in a same plane. The second plate surface 103a and the second support surface 3b may support the flexible display 4 when the electronic device is in the unfolded state. This helps smoothly support the flexible display 4, helps simplify a mechanism design, reduce a bonding difficulty of the flexible display, and improve structural reliability of the flexible display.

When the electronic device in this application is in the folded state, an included angle between the first plate surface 102a and the first support surface 2b may be greater than an included angle between the second plate surface 103a and the second support surface 3b, to form the display accommodating space between the first plate surface 102a, the second plate surface 103a, and the bearing surface 1020a. It can be learned from the foregoing description of the hinge mechanism 1 that, the display accommodating space is the tilted triangular interval. This can help reduce the volume and the weight of the hinge mechanism 1, enable the electronic device to reserve sufficient space for disposing other components. This helps improve performance of the electronic device. In addition, the bent part, of the flexible display 4, accommodated in the display accommodating space is in the asymmetrical water-drop-like form. This helps reduce the width of bent part of the flexible display 4, and improve user experience.

It should be understood that, to implement the form of the electronic device, this application is not limited to embodiments of the hinge mechanisms mentioned above, provided that the hinge mechanisms in the following states can be implemented:

When the electronic device is in the folded state, the included angle between the first plate surface 102a and the first support surface 2b is greater than the included angle between the second plate surface 103a and the second support surface 3b, to form the display accommodating space between the first plate surface 102a, the second plate surface 103a, and the bearing surface 1020a; or when the electronic device is in the folded state, the included angle between the first plate surface 102a of the first support plate 102 and the bearing surface 1020a is less than the included angle between the second plate surface 103a of the second support plate 103 and the bearing surface 1020a, to form, between the first plate surface 102a, the second plate surface 103a, and the bearing surface 1020a, the triangular display accommodating space that tilts toward the side of the first support plate 102.

In addition, in this application, the first track slot of the first support plate 102 can be appropriately designed, so that when the electronic device is in the folded state, enough accommodating space is formed between the two support plates and the base to accommodate the bent part of the flexible display 4. This can avoid the gap at the hinge mechanism 1 of the electronic device, and ensure that the form of the electronic device in the folded state is complete; and can avoid damage to the flexible display 4 caused by a foreign matter inserted into the electronic device at the hinge mechanism 1, and implement the thinning design of the overall thickness of the electronic device.

In addition, as shown in FIG. 4, a first groove 201 may be disposed at an end part, of the first housing 2, facing the hinge mechanism 1, and a second groove 301 may be disposed at an end part, of the second housing 3, facing the hinge mechanism 1. In this case, one housing mounting bracket 1015 may be accommodated in the first groove 201, and the other housing mounting bracket 1015 may be accommodated in the second groove 301. In this way, when the electronic device is in the unfolded state, the hinge mechanism 1 can be accommodated in an accommodating part formed by folding the first groove 201 and the second groove 301, so that the electronic device has appearance effect of an integrated design. This improves appearance aesthetics of the electronic device.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A hinge mechanism, used in a foldable electronic device, wherein the hinge mechanism is disposed corresponding to a bendable part of a flexible display of the electronic device, the electronic device is unfolded or folded via the hinge mechanism, and the hinge mechanism comprises a base and a main hinge module;
the base comprises a bearing surface, and the bearing surface is configured to support the flexible display;
the main hinge module comprises a first rotating component and a second rotating component, and the first rotating component and the second rotating component are disposed on two opposite sides of the base;
the first rotating component comprises a first support plate, the first support plate comprises a first plate surface, and the first plate surface is configured to support the flexible display;
the second rotating component comprises a second support plate, the second support plate comprises a second plate surface, and the second plate surface is configured to support the flexible display; and
when the hinge mechanism is in a folded state, an included angle between the first plate surface and the bearing surface is less than an included angle between the second plate surface and the bearing surface, to form, between the first plate surface, the second plate surface, and the bearing surface, display accommodating space for accommodating the bendable part of the flexible display.

2. The hinge mechanism according to claim 1, wherein the first rotating component further comprises a first support arm and a housing mounting bracket, the first support arm is rotatably connected to the base, the first support arm is slidably connected to the housing mounting bracket, and the first support plate is rotatably connected to the housing mounting bracket;
the second support plate is rotatably connected to the base; and
when the first rotating component and the second rotating component rotate towards each other, an end, of the first support plate, close to the base moves in a direction away from the base.

3. The hinge mechanism according to claim 2, wherein the housing mounting bracket is provided with a rotating slot, the first support plate is provided with a rotating part, the rotating part is installed in the rotating slot, and the rotating part can rotate along a slot surface of the rotating slot.

4. The hinge mechanism according to claim 2 or 3, wherein the first rotating component further comprises a swing arm, the swing arm is rotatably connected to the base, and a rotation axis of the first support arm is parallel to but does not overlap a rotation axis of the swing arm.

5. The hinge mechanism according to claim 4, wherein the first support plate is slidably connected to the first support arm, and/or the first support plate is slidably connected to the swing arm.

6. The hinge mechanism according to claim 5, wherein when the first support plate is slidably connected to the first support arm, a first guiding part is disposed on the first support plate, and the first guiding part has a first track slot; and a first guiding structure is disposed on the first support arm, and the first guiding structure is inserted into the first track slot and can slide along the first track slot; and/or
when the first support plate is slidably connected to the swing arm, a first guiding part is disposed on the first support plate, and the first guiding part has a first track slot; and a first guiding structure is disposed on the swing arm, and the first guiding structure is inserted into the first track slot and can slide along the first track slot.

7. The hinge mechanism according to any one of claims 4 to 6, wherein a first arc-shaped slot is disposed on the base, a first arc-shaped rotation block is disposed at an end, of the swing arm, rotatably connected to the base, and the first arc-shaped rotation block is accommodated in the first arc-shaped slot and can rotate along an arc-shaped surface of the first arc-shaped slot.

8. The hinge mechanism according to claim 7, wherein the hinge mechanism further comprises a cover plate, the cover plate covers the base, an arc-shaped protrusion is disposed on a surface, of the cover plate, facing the first arc-shaped slot, and the first arc-shaped rotation block is inserted between the arc-shaped protrusion and the first arc-shaped slot.

9. The hinge mechanism according to any one of claims 4 to 8, wherein the swing arm is slidably connected to the housing mounting bracket; and
a first sliding groove extending in a first direction and a second sliding groove extending in a second direction are disposed on the housing mounting bracket, the first support arm can slide in the first sliding groove, the swing arm can slide in the second sliding groove, a projection along the first direction in a first cross section is not parallel to a projection along the second direction in the first cross section, and the first cross section is a reference plane perpendicular to the rotation axis of the first support arm and the rotation axis of the swing arm.

10. The hinge mechanism according to claim 9, wherein neither of angles at which the first support arm and the swing arm rotate relative to the base is greater than 90°.

11. The hinge mechanism according to claim 9 or 10, wherein the second sliding groove is provided with a second sliding rail, the swing arm is provided with a second sliding block, the second sliding block is clamped on the second sliding rail, and the second sliding block can slide along the second sliding rail.

12. The hinge mechanism according to claim 11, wherein the second sliding rail is a straight-line sliding rail.

13. The hinge mechanism according to claim 12, wherein the housing mounting bracket comprises a first surface, the first surface is a side surface, of the housing mounting bracket, facing the flexible display, the straight-line sliding rail has an opening located on the first surface, and when the hinge mechanism is in an unfolded state, the straight-line sliding rail extends from the opening to the base.

14. The hinge mechanism according to claim 11, wherein the second sliding rail is an arc-shaped sliding rail.

15. The hinge mechanism according to claim 14, wherein when the hinge mechanism is in an unfolded state, an axis center of the arc-shaped sliding rail is located on a side, of the arc-shaped sliding rail, away from the base.

16. The hinge mechanism according to any one of claims 4 to 15, wherein the main hinge module further comprises a drive connecting rod, and the drive connecting rod is located between the first support arm and the swing arm; the drive connecting rod comprises a first connection part and a second connection part, the first connection part is rotatably connected to the first support arm through a first connecting rod, and the second connection part is rotatably connected to the swing arm through a second connecting rod; and axes of the first connecting rod and the second connecting rod do not overlap.

17. The hinge mechanism according to any one of claims 4 to 15, wherein the main hinge module further comprises a drive connecting rod, and the drive connecting rod is located between the first support arm and the swing arm; and the drive connecting rod comprises a first connection part and a second connection part, the first connection part is slidably connected to the swing arm through a first connecting rod, and the second connection part is fastened to the first support arm.

18. The hinge mechanism according to claim 17, wherein a guiding slot is disposed at an end part, of the swing arm, facing the first support arm, and the first connecting rod is inserted into the guiding slot and can slide along a slot surface of the guiding slot.

19. The hinge mechanism according to any one of claims 16 to 18, wherein the second sliding groove is provided with the second sliding rail, the swing arm is provided with the second sliding block, the second sliding block can slide along the second sliding rail, and the second sliding block is in clearance fit with the second sliding rail.

20. The hinge mechanism according to claim 19, wherein a shape of the second sliding block matches a shape of the second sliding rail, or the second sliding block is a pin shaft.

21. The hinge mechanism according to any one of claims 4 to 8, wherein the swing arm is rotatably connected to the housing mounting bracket.

22. The hinge mechanism according to claim 21, wherein the hinge mechanism further comprises an end cover and a rotation member, the end cover has an accommodation part, the base is disposed in the accommodation part, one end of the rotation member presses against a bottom surface, of the end cover, facing the base, and the other end of the rotation member is rotatably connected to the base; and
when the first rotating component and the second rotating component rotate away from each other, the swing arm rotates around the base to drive the end cover to rotate around the base, and a rotation direction of the end cover is the same as a rotation direction of the swing arm.

23. The hinge mechanism according to claim 22, wherein the hinge mechanism further comprises a resetting element, and the rotation member is rotatably connected to the base via the resetting element; and
when the first rotating component and the second rotating component rotate towards each other, the swing arm rotates around the base; and the rotation member rotates around the base under the action of the resetting element, the rotation member rotates to drive the end cover to rotate, and the rotation direction of the end cover is the same as the rotation direction of the swing arm.

24. The hinge mechanism according to any one of claims 1 to 23, wherein a second arc-shaped slot is further disposed on the base, a second arc-shaped rotation block is disposed at an end, of the second support plate, rotatably connected to the base, and the second arc-shaped rotation block is accommodated in the second arc-shaped slot and can rotate along an arc-shaped surface of the second arc-shaped slot.

25. The hinge mechanism according to any one of claims 1 to 23, wherein the second support plate is rotatably connected to the base via a rotating shaft.

26. The hinge mechanism according to claim 24 or 25, wherein the second rotating component further comprises a second support arm, the second support arm is rotatably connected to the base, the second support plate is rotatably connected to the second support arm through a connecting rod component, and the connecting rod component comprises at least two connecting rod pieces hinged with each other; or
the second support plate is provided with a second guiding part, and the second guiding part has a second track slot; the second support arm is provided with a second guiding structure, and the second guiding structure is inserted into the second track slot and can slide along the second track slot.

27. The hinge mechanism according to claim 26, wherein the main hinge module further comprises a synchronization component, the synchronization component comprises a first drive gear disposed at an end part of the first support arm and a second drive gear disposed at an end part of the second support arm, and the first drive gear and the second drive gear are engaged.

28. The hinge mechanism according to claim 27, wherein the synchronization component further comprises an even number of driven gears, the even number of driven gears are located between the first drive gear and the second drive gear, and the first drive gear and the second drive gear rotate synchronously via the even number of driven gears.

29. An electronic device, comprising a first housing, a second housing, a flexible display, and the hinge mechanism according to any one of claims 1 to 28, wherein
the first housing and the second housing are separately disposed on two opposite sides of the hinge mechanism, the housing mounting bracket is fastened to the first housing, and the second support plate is fastened to the second housing; and
the flexible display continuously covers the first housing, the second housing, and the hinge mechanism, and the flexible display is fastened to the first housing and the second housing.

30. The electronic device according to claim 29, wherein the flexible display is bonded to the first plate surface of the first support plate and the second plate surface of the second support plate.

31. The electronic device according to claim 30, wherein the flexible display is bonded to a partial area of the first plate surface, and the flexible display is bonded to a partial area of the second plate surface.

32. An electronic device, comprising a hinge mechanism, a first housing, a second housing, and a flexible display, wherein the hinge mechanism is disposed corresponding to a bendable part of the flexible display, and the electronic device is unfolded or folded via the hinge mechanism;
the hinge mechanism comprises a base and a main hinge module, the base comprises a bearing surface, and the bearing surface is configured to support the flexible display;
the first housing and the second housing are separately disposed on two opposite sides of the hinge mechanism, the first housing has a first support surface, the first support surface is configured to support the flexible display, the second housing has a second support surface, and the second support surface is configured to support the flexible display;
the flexible display continuously covers the first housing, the second housing, and the hinge mechanism, and the flexible display is fastened to the first housing and the second housing;
the main hinge module comprises a first rotating component and a second rotating component, the first rotating component and the second rotating component are disposed on two opposite sides of the base, the first rotating component is disposed corresponding to the first housing, and the second rotating component is disposed corresponding to the second housing;
the first rotating component comprises a first support plate, the first support plate comprises a first plate surface, and the first plate surface is configured to support the flexible display;
the second rotating component comprises a second support plate, the second support plate comprises a second plate surface, and the second plate surface is configured to support the flexible display; and
when the electronic device is in a folded state, an included angle between the first plate surface and the first support surface is greater than an included angle between the second plate surface and the second support surface, to form, between the first plate surface, the second plate surface, and the bearing surface, display accommodating space for accommodating the bendable part of the flexible display.

33. The electronic device according to claim 32, wherein when the electronic device is in the folded state, the second plate surface and the second support surface are located in a same plane.

34. The electronic device according to claim 32 or 33, wherein the flexible display is bonded to the first plate surface of the first support plate and the second plate surface of the second support plate.

35. The electronic device according to claim 34, wherein the flexible display is bonded to a partial area of the first plate surface, and the flexible display is bonded to a partial area of the second plate surface.

36. The electronic device according to any one of claims 32 to 35, wherein the first rotating component further comprises a first support arm and a housing mounting bracket, the first support arm is rotatably connected to the base, the first support arm is slidably connected to the housing mounting bracket, the first support plate is rotatably connected to the housing mounting bracket, and the second support plate is rotatably connected to the base; and
when the first rotating component and the second rotating component rotate towards each other, an end, of the first support plate, close to the base moves in a direction away from the base.

37. The electronic device according to claim 36, wherein the housing mounting bracket is provided with a rotating slot, the first support plate is provided with a rotating part, the rotating part is installed in the rotating slot, and the rotating part can rotate along a slot surface of the rotating slot.

38. The electronic device according to claim 36 or 37, wherein the first rotating component further comprises a swing arm, the swing arm is rotatably connected to the base, and a rotation axis of the first support arm is parallel to but does not overlap a rotation axis of the swing arm.

39. The electronic device according to claim 38, wherein the first support plate is slidably connected to the first support arm, and/or the first support plate is slidably connected to the swing arm.

40. The electronic device according to claim 39, wherein when the first support plate is slidably connected to the first support arm, a first guiding part is disposed on the first support plate, and the first guiding part has a first track slot; and a first guiding structure is disposed on the first support arm, and the first guiding structure is inserted into the first track slot and can slide along the first track slot; and/or
when the first support plate is slidably connected to the swing arm, a first guiding part is disposed on the first support plate, and the first guiding part has a first track slot; and a first guiding structure is disposed on the swing arm, and the first guiding structure is inserted into the first track slot and can slide along the first track slot.

41. The electronic device according to any one of claims 38 to 40, wherein a first arc-shaped slot is disposed on the base, a first arc-shaped rotation block is disposed at an end, of the swing arm, rotatably connected to the base, and the first arc-shaped rotation block is accommodated in the first arc-shaped slot and can rotate along an arc-shaped surface of the first arc-shaped slot.

42. The electronic device according to claim 41, wherein the hinge mechanism further comprises a cover plate, the cover plate covers the base, an arc-shaped protrusion is disposed on a surface, of the cover plate, facing the first arc-shaped slot, and the first arc-shaped rotation block is inserted between the arc-shaped protrusion and the first arc-shaped slot.

43. The electronic device according to any one of claims 38 to 42, wherein the swing arm is slidably connected to the housing mounting bracket; and
a first sliding groove extending in a first direction and a second sliding groove extending in a second direction are disposed on the housing mounting bracket, the first support arm can slide in the first sliding groove, the swing arm can slide in the second sliding groove, a projection along the first direction in a first cross section is not parallel to a projection along the second direction in the first cross section, and the first cross section is a reference plane perpendicular to the rotation axis of the first support arm and the rotation axis of the swing arm.

44. The electronic device according to claim 43, wherein neither of angles at which the first support arm and the swing arm rotate relative to the base is greater than 90°.

45. The electronic device according to claim 43 or 44, wherein the second sliding groove is provided with a second sliding rail, the swing arm is provided with a second sliding block, the second sliding block is clamped on the second sliding rail, and the second sliding block can slide along the second sliding rail.

46. The electronic device according to claim 45, wherein the second sliding rail is a straight-line sliding rail.

47. The electronic device according to claim 46, wherein the housing mounting bracket comprises a first surface, the first surface is a side surface, of the housing mounting bracket, facing the flexible display, the straight-line sliding rail has an opening located on the first surface, and when the hinge mechanism is in an unfolded state, the straight-line sliding rail extends from the opening to the base.

48. The electronic device according to claim 45, wherein the second sliding rail is an arc-shaped sliding rail.

49. The electronic device according to claim 48, wherein when the hinge mechanism is in an unfolded state, an axis center of the arc-shaped sliding rail is located on a side, of the arc-shaped sliding rail, away from the base.

50. The electronic device according to any one of claims 38 to 49, wherein the main hinge module further comprises a drive connecting rod, and the drive connecting rod is located between the first support arm and the swing arm; the drive connecting rod comprises a first connection part and a second connection part, the first connection part is rotatably connected to the first support arm through a first connecting rod, and the second connection part is rotatably connected to the swing arm through a second connecting rod; and axes of the first connecting rod and the second connecting rod do not overlap.

51. The electronic device according to any one of claims 38 to 49, wherein the main hinge module further comprises a drive connecting rod, and the drive connecting rod is located between the first support arm and the swing arm; and the drive connecting rod comprises a first connection part and a second connection part, the first connection part is slidably connected to the swing arm through a first connecting rod, and the second connection part is fastened to the first support arm.

52. The electronic device according to claim 51, wherein a guiding slot is disposed at an end part, of the swing arm, facing the first support arm, and the first connecting rod is inserted into the guiding slot and can slide along a slot surface of the guiding slot.

53. The electronic device according to any one of claims 50 to 52, wherein the second sliding groove is provided with the second sliding rail, the swing arm is provided with the second sliding block, the second sliding block can slide along the second sliding rail, and the second sliding block is in clearance fit with the second sliding rail.

54. The electronic device according to claim 53, wherein a shape of the second sliding block matches a shape of the second sliding rail, or the second sliding block is a pin shaft.

55. The electronic device according to any one of claims 38 to 42, wherein the swing arm is rotatably connected to the housing mounting bracket.

56. The electronic device according to claim 55, wherein the hinge mechanism further comprises an end cover and a rotation member, the end cover has an accommodation part, the base is disposed in the accommodation part, one end of the rotation member presses against a bottom surface, of the end cover, facing the base, and the other end of the rotation member is rotatably connected to the base; and
when the first rotating component and the second rotating component rotate away from each other, the swing arm rotates around the base to drive the end cover to rotate around the base, and a rotation direction of the end cover is the same as a rotation direction of the swing arm.

57. The electronic device according to claim 56, wherein the hinge mechanism further comprises a resetting element, and the rotation member is rotatably connected to the base via the resetting element; and
when the first rotating component and the second rotating component rotate towards each other, the swing arm rotates around the base; and the rotation member rotates around the base under the action of the resetting element, the rotation member rotates to drive the end cover to rotate, and the rotation direction of the end cover is the same as the rotation direction of the swing arm.

58. The electronic device according to any one of claims 32 to 57, wherein a second arc-shaped slot is further disposed on the base, a second arc-shaped rotation block is disposed at an end, of the second support plate, rotatably connected to the base, and the second arc-shaped rotation block is accommodated in the second arc-shaped slot and can rotate along an arc-shaped surface of the second arc-shaped slot.

59. The electronic device according to any one of claims 32 to 57, wherein the second support plate is rotatably connected to the base via a rotating shaft.

60. The electronic device according to claim 58 or 59, wherein the second rotating component further comprises a second support arm, the second support arm is rotatably connected to the base, the second support plate is rotatably connected to the second support arm through a connecting rod component, and the connecting rod component comprises at least two connecting rod pieces hinged with each other; or
the second support plate is provided with a second guiding part, and the second guiding part has a second track slot; the second support arm is provided with a second guiding structure, and the second guiding structure is inserted into the second track slot and can slide along the second track slot.
